# EUROPEAN PATENT APPLICATION

(11) **EP 4 852 328 A1**
(43) Date of publication of application: **09.12.2026**
(21) Application number: 24923286.9
(22) Date of filing: 02.09.2024
(51) Int. Cl.: H03M 13/11

(54) **ENCODING METHOD AND APPARATUS, DECODING METHOD AND APPARATUS AND STORAGE MEDIUM**

(30) Priority: 05.02.2024 CN 202410173298
(71) Applicant: ZTE Corporation, Shenzhen, Guangdong 518057 (CN)
(72) Inventor: YANG, Xiaoling, Shenzhen, Guangdong 518057 (CN); XU, Jin, Shenzhen, Guangdong 518057 (CN); LIANG, Chulong, Shenzhen, Guangdong 518057 (CN); LI, Liguang, Shenzhen, Guangdong 518057 (CN); YU, Guanghui, Shenzhen, Guangdong 518057 (CN); FU, Qiang, Shenzhen, Guangdong 518057 (CN); KANG, Jian, Shenzhen, Guangdong 518057 (CN)
(74) Representative: Ziebig Hengelhaupt Intellectual Property Attorneys Patentanwaltskanzlei PartGmbB
(86) International application number: PCT/CN2024/116293
(87) International publication number: WO 2025/167076

(57) **Abstract**

Provided are an encoding method and apparatus, a decoding method and apparatus, and a storage medium. The encoding method comprises: determining a parity check matrix, wherein the dimension of the parity check matrix is determined on the basis of the dimension of a binary extended matrix, the binary extended matrix is obtained by hashing an exponential matrix on the basis of a lifting factor, and the lifting factor is determined on the basis of a binary fundamental matrix, an information bit sequence, and the order of a non-binary low density parity check code (NB-LDPC); and performing NB-LDPC encoding on the information bit sequence on the basis of the parity check matrix or a generator matrix corresponding to the parity check matrix, to obtain an encoding sequence.

## Description

The present disclosure claims a priority to Chinese Patent Application No. 202410173298.X, filed on February 05, 2024, the entire content of which is incorporated herein by reference.

### TECHNICAL FIELD

The present disclosure relates to the field of communication technologies, and in particular, to an encoding method, a decoding method, an apparatus, and a storage medium.

### BACKGROUND

With the rapid development of technologies such as big data, cloud computing, and time-sensitive networks, a user equipment in a wireless communication network has experienced explosive growth. Wireless communication networks will carry diverse applications and massive amounts of data, which imposes high requirements on data transmission rate, throughput, reliability, latency, etc. Error control coding that approaches the Shannon limit, i.e., low density parity check codes (LDPC), may be adopted. LDPC is a special class of linear block codes based on sparse parity check matrices, characterized by low decoding complexity, high throughput capability, flexible structure, etc., and thus has been widely used in practical communication systems.

Non-binary low density parity check (NB-LDPC) codes extend and improve upon LDPC codes by expanding both information bits and parity check bits to the non-binary fields, thereby enhancing error correction performance and coding efficiency, and is more suitable for communication systems with strict latency requirements and high reliability requirements.

### SUMMARY

In a first aspect, the embodiments of the present disclosure provide an encoding method. The encoding method includes:
determining a parity check matrix, where a dimension of the parity check matrix is determined based on a dimension of a binary extension matrix, the binary extension matrix is obtained by hashing an exponent matrix based on a lifting factor, and the lifting factor is determined based on the binary base matrix, an information bit sequence, and an order of non-binary low density parity check (NB-LDPC) codes; and
performing NB-LDPC encoding on the information bit sequence according to the parity check matrix or a generator matrix corresponding to the parity check matrix, to obtain an encoded sequence.

In a second aspect, the embodiments of the present disclosure provide a decoding method. The decoding method includes:
receiving an encoded sequence; and
decoding the encoded sequence based on a parity check matrix of non-binary low density parity check (NB-LDPC) codes, to obtain an information bit sequence; where a dimension of the parity check matrix is determined based on a dimension of a binary extension matrix, the binary extension matrix is obtained by hashing an exponent matrix based on a lifting factor, and the lifting factor is determined based on a binary base matrix, the information bit sequence, and an order of the NB-LDPC codes.

In a third aspect, the embodiments of the present disclosure provide an encoding apparatus. The encoding apparatus includes: a determining module and an encoding module;
the determining module, is configured to determine a parity check matrix, where a dimension of the parity check matrix is determined based on a dimension of a binary extension matrix, the binary extension matrix is obtained by hashing an exponent matrix based on a lifting factor, and the lifting factor is determined based on a binary base matrix, an information bit sequence, and an order of non-binary low density parity check (NB-LDPC) codes;
the encoding module, is configured to perform NB-LDPC encoding on the information bit sequence according to the parity check matrix or a generator matrix corresponding to the parity check matrix, to obtain an encoded sequence.

In a fourth aspect, the embodiments of the present disclosure provide a decoding apparatus. The decoding apparatus includes: a receiving module and a decoding module;
the receiving module, is configured to receive an encoded sequence; and
the decoding module, is configured to decode the encoded sequence based on a parity check matrix of non-binary low density parity check (NB-LDPC) codes, to obtain an information bit sequence; where a dimension of the parity check matrix is determined based on a dimension of a binary extension matrix, the binary extension matrix is obtained by hashing an exponent matrix based on a lifting factor, and the lifting factor is determined based on a binary base matrix, the information bit sequence, and an order of the NB-LDPC codes.

In a fifth aspect, the embodiments of the present disclosure further provide a communication apparatus. The communication apparatus includes: a memory and a processor; the memory is coupled with the processor; the memory is configured to store instructions executable by the processor; and the processor, upon executing the instructions, performs any one of the methods provided in the first aspect or the second aspect.

In a sixth aspect, the embodiments of the present disclosure provide a computer program product containing computer instructions, and the computer instructions, upon being executed on a computer, enable the computer to perform any one of the methods provided in the first aspect or the second aspect above.

In a seventh aspect, the embodiments of the present disclosure provide a computer program product, and the computer program product includes computer program instructions, and the computer program instructions, upon being executed by a processor, implement any one of the methods provided in the first aspect or the second aspect above.

### BRIEF DESCRIPTION OF THE DRAWINGS

In order to illustrate technical solutions in the present disclosure more clearly, the drawings to be used in some embodiments of the present disclosure will be introduced briefly. Obviously, the drawings to be described below are merely drawings of some embodiments of the present disclosure, and those ordinary skilled in the art may also obtain other drawings according to these drawings.
FIG. 1 is a schematic diagram of an architecture of a communication system according to some embodiments.
FIG. 2 is a data processing flow chart according to some embodiments.
FIG. 3 is a schematic flowchart of an encoding method according to some embodiments.
FIG. 4 is a schematic flowchart of another encoding method according to some embodiments.
FIG. 5 is a schematic flowchart of a decoding method according to some embodiments.
FIG. 6 is a schematic diagram of components of an encoding apparatus according to some embodiments.
FIG. 7 is a schematic diagram of components of a decoding apparatus according to some embodiments.
FIG. 8 is a schematic diagram of components of a communication apparatus according to some embodiments.

### DETAILED DESCRIPTION

The technical solutions in the embodiments of the present disclosure will be described clearly and completely below in conjunction with the drawings in the embodiments of the present disclosure. Obviously, the described embodiments are only a part of the embodiments of the present disclosure, not all of the embodiments. Based on the embodiments in the present disclosure, all other embodiments obtained by those ordinary skilled without creative efforts shall fall within the protection scope of the present disclosure.

In the description of the present disclosure, unless otherwise specified, the symbol "/" means "or", for example, "A/B" may mean A or B. Herein, "and/or" merely describes an association relationship of associated objects, and means that there are three kinds of relationships, and for example, A and/or B may mean: only A, only B, and both A and B. In addition, "at least one" means one or more, and the "more" or variants thereof means two or more. Expressions, such as "first" and "second", etc., do not limit the number and execution order, and the expressions, such as "first" and "second", etc., also do not necessarily limit different items.

It should be noted that in the present disclosure, the expressions such as "exemplary/exemplarily" or "for example" are used to present an example, illustration, or explanation. Any embodiment or design scheme described with "exemplary/exemplarily" or "for example" in the present disclosure should not be construed as preferred or advantageous over other embodiments or design schemes. Rather, the usage of the expressions, such as "exemplary /exemplarily" or "for example", etc., is intended to present relevant concepts in a detailed manner.

LDPC codes are a class of linear block codes defined by a sparse parity check matrix or bipartite graphs, with advantages such as approaching Shannon limit performance, linear-time encoding, low decoding complexity, parallel decoding, and being superior to Turbo codes under long code length conditions. In binary LDPC codes, all non-zero elements in the parity-check matrix are "1". When the non-zero elements of the parity check matrix are taken from a larger Galois field set, a linear block code over a larger symbol set is defined, and such codes may be referred to as non-binary LDPC codes. Moreover, under short-to-medium code lengths, compared with binary LDPC codes of the same bit length, non-binary LDPC codes have advantages as follows: higher coding gain, lower error floor, stronger burst error resistance, and easier combination with higher-order modulation. Therefore, non-binary LDPC codes are expected to be applied to communication systems with strict latency requirements and extremely high reliability requirements. However, currently, there are still many problems with non-binary LDPC codes, such as relatively high storage space, and relatively complex matrix construction and encoding processes, which hinder the application of non-binary LDPC codes in practical communication systems.

In view of this, the present disclosure provides an encoding method, and the encoding method includes: determining a parity check matrix, where a dimension of the parity check matrix is determined based on a dimension of a binary extension matrix, the binary extension matrix is obtained by hashing an exponent matrix based on a lifting factor, and the lifting factor is determined based on a binary base matrix, an information bit sequence, and an order of non-binary low density parity check (NB-LDPC) codes; and performing NB-LDPC encoding on the information bit sequence according to the parity check matrix or a generator matrix corresponding to the parity check matrix, to obtain an encoded sequence. In this way, the parity check matrix may be determined based on the determined binary extension matrix, exponent matrix, lifting factor, etc., so that it is unnecessary to store the parity check matrix when performing NB-LDPC code encoding, thereby reducing the storage space required in the NB-LDPC code encoding process.

Correspondingly, the present disclosure further provides a decoding method, and the method includes: receiving an encoded sequence; decoding the encoded sequence based on a parity check matrix of non-binary low density parity check (NB-LDPC) codes, to obtain an information bit sequence; where a dimension of the parity check matrix is determined based on a dimension of a binary extension matrix, the binary extension matrix is obtained by hashing an exponent matrix based on a lifting factor, and the lifting factor is determined based on a binary base matrix, the information bit sequence, and an order of the NB-LDPC codes.

The technical solutions provided in the embodiments of the present disclosure may be applied to various mobile communication networks, for example, new radio (New Radio, NR) mobile communication networks using the fifth generation mobile communication technology (5th generation mobile networks, 5G), future mobile communication networks or multiple communication fusion systems, etc., which are not limited to the embodiments of the present disclosure.

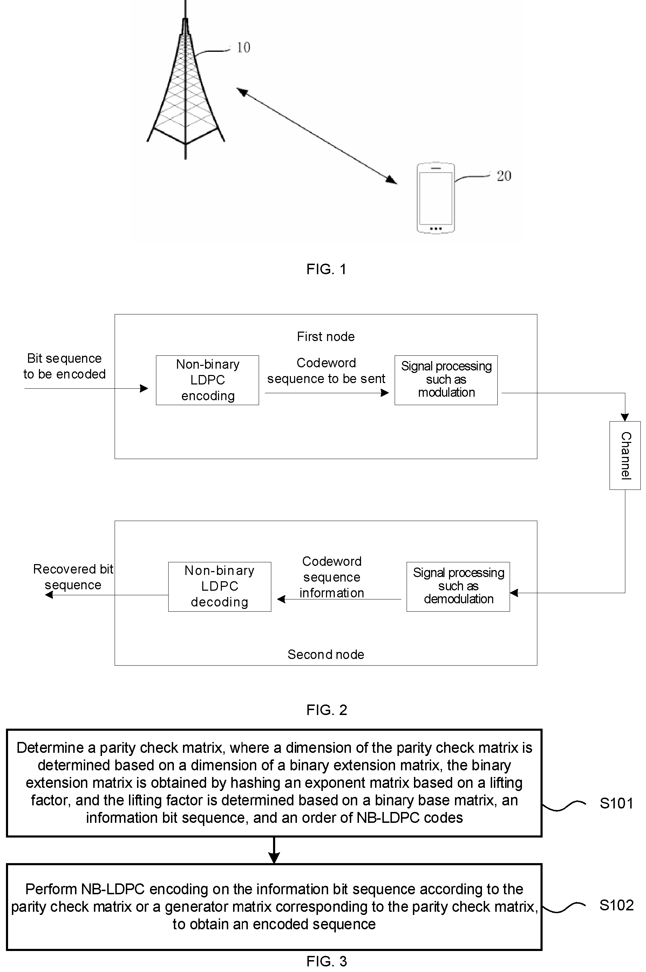

FIG. 1 shows a schematic diagram of an architecture of a communication system provided by the embodiments of the present disclosure. As shown in FIG. 1, the communication system includes one or more first nodes 10 and one or more second nodes 20.

In some embodiments, the first node 10 may be a base station, configured to provide radio access services for a plurality of terminals. For example, a base station provides a service coverage area (also referred to as a cell). A terminal entering the area may communicate with the base station by a wireless signal, to receive a radio access service provided by the base station.

In some embodiments, a base station may be a base station or an evolutional base station (evolutional node B, eNB or eNodeB) in long term evolution (LTE), long term evolution advanced (LTEA), a base station device in a 5G network, or a base station in a future communication system, etc. The base station may include various network side devices such as macro base stations, micro base stations, home base stations, remote radio devices, reconfigurable intelligent surfaces (RISs), routers, wireless fidelity (WiFi) devices.

In some embodiments, the second node 20 may be a terminal, and the terminal may be a device with a wireless transceiving function, may be deployed on land (including indoors or outdoors, handheld, worn or in-vehicle); may also be deployed on the water (e.g., on a ship, etc.); may also be deployed in the air (e.g., on an airplane, a balloon and a satellite, etc.). The terminal may be a mobile phone, a pad, a computer with a wireless transceiver function, a virtual reality (Virtual Reality, VR) terminal, an augmented reality (Augmented Reality, AR) terminal, a wireless terminal in industrial control, a wireless terminal in self driving, a wireless terminal in remote medical, a wireless terminal in a smart grid, a wireless terminal in transportation safety, a wireless terminal in a smart city, a wireless terminal in a smart home, etc. The embodiments of the present disclosure do not limit the application scenarios. The terminal sometimes may also be referred to as a user, a user equipment (User Equipment, UE), an access terminal, a UE unit, a UE station, a mobile station, a mobile platform, a remote station, a remote terminal, a mobile device, a UE terminal, a wireless communication device, a UE agent, or a UE apparatus, etc., which is not limited to the embodiments of the present disclosure.

The embodiments of the present disclosure may be applied to downlink data transmission, may also be applied to uplink data transmission, and may further be applied to device-to-device data transmission. For the downlink data transmission, the sending end is a base station, and the corresponding receiving end is a terminal. For the uplink data transmission, the sending end is a terminal, and the corresponding receiving end is a base station. For device-to-device data transmission, the sending end is a terminal, and the corresponding receiving end is also a terminal. Both the sending end and the receiving end in the present disclosure may include an encoding apparatus and/or a decoding apparatus, so that to-be-sent information may be modulated and encoded, and received encoded information may be demodulated and decoded, thereby implementing information transmission between the sending end device and the receiving end device, which is not limited to the embodiments of the present disclosure.

It should be noted that, FIG. 1 is only an exemplary framework diagram, and a number of devices and names of the various devices included in FIG. 1 are not limited, and in addition to the devices shown in FIG. 1, the communication system may also include other devices, such as a core network device.

The embodiments of the present disclosure do not limit the application scenarios. The system architectures and the service scenarios described in the embodiments of the present disclosure are provided for more clearly explaining the technical solutions of the embodiments of the present disclosure, and do not constitute a limitation on the technical solutions provided in the embodiments of the present disclosure, and the ordinary skilled in the art may know that with the evolution of the network architectures and the emergence of new service scenarios, the technical solutions provided in the embodiments of the present disclosure are also applicable to similar technical problems.

FIG. 2 is a data processing flowchart between a first node and a second node. As shown in FIG. 2, the first node may perform quasi-cyclic non-binary LDPC encoding on a to-be-encoded bit sequence, to obtain a to-be-sent codeword sequence, and after signal processing such as modulation, the first node sends a transmission signal containing the to-be-sent codeword sequence to the second node via a channel. The second node, after receiving the transmission signal, may perform signal processing such as demodulation on the signal, to obtain codeword sequence information, and recover an information bit sequence through non-binary LDPC decoding.

LDPC is defined by a sparse (or low-density) parity check matrix, and decoding performance may be improved through iterative decoding, for example, using belief propagation decoding.

Parity check matrix H of a quasi-cyclic LDPC code may be a matrix of (*M_{b}* ×*Z*)×(*N_{b}* × *Z).* Exemplarily, the check matrix H has a form as follows: $H = \left[\begin{matrix}{P}^{{h}_{0 , 0}} & {P}^{{h}_{0 , 1}} & {P}^{{h}_{0 , 2}} & … & {P}^{{h}_{0 , {N}_{b} - 1}} \\ {P}^{{h}_{1 , 0}} & {P}^{{h}_{1 , 1}} & {P}^{{h}_{1 , 2}} & … & {P}^{{h}_{1 , {N}_{b} - 1}} \\ ⋮ & ⋮ & ⋮ & ⋱ & ⋮ \\ {P}^{{h}_{{M}_{b} - 1 , 0}} & {P}^{{h}_{{M}_{b} - 1 , 1}} & {P}^{{h}_{{M}_{b} - 1 , 2}} & … & {P}^{{h}_{{M}_{b} - 1 , {N}_{b} - 1}}\end{matrix}\right] = {P}^{{H}_{w}}$

The matrix may be composed of *M_{b}* × *N_{b}* block sub-matrices, and each block matrix is a sparse matrix with a dimension of Z × Z or an all-zero square matrix. Exemplarily, the sparse matrix may be an identity matrix and a cyclic shift matrix (e.g., right shift) thereof. Such block matrices may be uniquely represented by a basic permutation matrix P and an exponent ${h}_{ij}^{b}$, for example, in a case of *h_{i,j}* = -1, the block matrix may be an all-zero square matrix. In a case where *h_{i,j}* is a non-negative integer, the block matrix may be the (*h_{i,j}*)-th power of the basic permutation matrix P. The standard permutation matrix P of Z × Z is as follows (an identity matrix cyclically shifted to the right by 1 bit may constitute the standard permutation matrix): $P = \left[\begin{matrix}0 & 1 & 0 & … & 0 \\ 0 & 0 & 1 & … & 0 \\ ⋮ & ⋮ & ⋮ & ⋱ & ⋮ \\ 0 & 0 & 0 & … & 1 \\ 1 & 0 & 0 & … & 0\end{matrix}\right]$

**Thus,** exponents *h_{i,j}* of the respective block matrices may constitute an exponent matrix *H_{w}* with *M_{b}* × *N_{b},* where i and j correspond to a row index and a column index of the exponent matrix *H_{w},* respectively. It can be seen that the elements in the exponent matrix *H_{w}* may be grouped into two types: elements indicating an all-zero square matrix and elements indicating the cyclic shift of an identity matrix (the value of the element indicates the size of the cyclic shift). *H_{w}* may be referred to as the exponent matrix of **H,** where H is the extension matrix of *H_{w},* Z is an extension factor, and, in actual LDPC encoding, the following relation may be satisfied: $Z = \frac{code length}{the number {N}_{b} of columns of {H}_{w}}$.

Therefore, a quasi-cyclic LDPC code may be generated based on the exponent matrix *H_{w},* the extension factor Z, and the selected basic permutation matrix P. Each element of the exponent matrix *H_{w}* corresponds to a Z×Z square matrix in its extension matrix **H,** including two possible types of elements, such as elements indicating an all-zero square matrix and elements indicating the cyclic shift of the identity matrix (indicating the cyclic shift size). Moreover, the extension matrix is the parity check matrix of the quasi-cyclic LDPC code.

In addition, an n×n binary circulant matrix H may be obtained by cyclically shifting an n-dimensional binary vector V. The i-th row (0≤i≤n-1) may be obtained by cyclically shifting the vector V to the right i times. Therefore, an n*n binary circulant matrix H may be uniquely determined by the n-dimensional binary vector V. Furthermore, assuming that a number of "1"s in the vector V is γ, and indices of these γ "1"s form a set B, it may be referred to as a generating set of the circulant matrix **H,** or a set of positions of "1" in the first row of the circulant matrix H. Generally, the generating set B may be denoted as *B* = {*b*₁,*b*₂,...*b_{γ}*}, 0 ≤ *bᵢ* ≤ n - 1,1 ≤ i ≤ y and when i≠j, *bᵢ* ≠ *bⱼ.* Therefore, the row weight and column weight of the circulant matrix H composed of the generating set B are both γ, so that the code directly defined by the circulant matrix is a (γ, γ) regular binary LDPC code.

As shown in FIG. 3, the embodiments of the present disclosure provide an encoding method, and the method includes S101 to S102.

In S101, a parity check matrix is determined.

A dimension of the parity check matrix is determined based on a dimension of a binary extension matrix, the binary extension matrix is obtained by hashing an exponent matrix based on a lifting factor, and the lifting factor is determined based on a binary base matrix, an information bit sequence, and an order of NB-LDPC codes.

In some embodiments, the binary base matrix, the lifting factor, the exponent matrix, and the binary extension matrix may be determined respectively, thereby the parity check matrix is determined. The determination method of respective matrices is exemplarily explained below:

### (1) Binary base matrix

The binary base matrix is an important concept in NB-LDPC technology. The binary base matrix may be used to define the parity check matrix of the NB-LDPC codes, and may also determine error correction performance of the codeword. The binary base matrix may be a square matrix, and the elements only contain 0 and 1.

In some embodiments, a dimension of the above binary base matrix is determined based on any one of: a preset dimension value; or a dimension value configured via signaling.

Exemplarily, the binary base matrix *B =* [*b_{i,j}*](0 ≤ *i,j < n),* a dimension of B is n*n. That is, the value of n or "n*n" may be determined based on the preset dimension value or the dimension value configured via signaling. In some embodiments, the signaling may come from a node or device receiving the encoded sequence.

In some embodiments, the binary base matrix in the present disclosure may have a non-full-rank circulant matrix structure.

It should be noted that, the non-full-rank circulant matrix structure of the binary base matrix refers to that there are some rows or columns in the binary base matrix that may be linearly represented by other rows or columns, so that a rank of the binary base matrix is smaller than its dimension size. In the binary base matrix, the non-full-rank circulant matrix structure refers to that there are some rows or columns in the matrix that may be obtained by cyclically shifting other rows or columns.

Therefore, in the technical solutions provided in the present disclosure, based on the non-full-rank circulant matrix structure of the binary base matrix, the characteristics of the circulant matrix may be utilized, and the cyclic shift relationship in the encoding and decoding processes may be used to detect and correct errors, thereby improving the error correction capability of the codeword. Moreover, in a case where there is a binary base matrix with a circulant structure, the cyclic shift relationship may be used to simplify the encoding and decoding processes, thereby reducing the computational amount and complexity of encoding and improving decoding efficiency.

In some embodiments, the above binary base matrix is determined based on at least one of:
a preset generating set;
a primitive polynomial of a Galois field; or
a binary cyclic code.

In an example, the binary base matrix may be determined by the preset generating set.

Exemplarily, the preset generating set is S = {*s*₁, *s*₂, ... , *s_{y}*}, *sᵢ* ≥ 0, 1 ≤ *i,j* ≤ *y.* Moreover, when *i ≠ j, sᵢ* ≠ *sⱼ.* Thus, the generating set *S* may be used to construct an n*n binary circulant matrix as the above binary base matrix. The binary base matrix satisfies *n* - 1 ≥ *sᵢ*, 1 ≤ *i* ≤ *y,* that is, the binary base matrix with a circulant matrix structure constructed based on the preset generating set S has a row weight and a column weight both being γ, and its rank is smaller than n (non-full-rank circulant matrix structure).

For example, in a case where the preset generating set is S={0 1 3 7} and n=15, the binary base matrix with a circulant matrix structure constructed based on the preset generating set S has a row weight and column weight both being 4, and its rank is 4, satisfying that the rank is smaller than the dimension n. Exemplarily, the binary base matrix B may be expressed as: $B = \left[\begin{matrix}1 & 1 & 0 & 1 & 0 & 0 & 0 & 1 & 0 & 0 & 0 & 0 & 0 & 0 & 0 \\ 0 & 1 & 1 & 0 & 1 & 0 & 0 & 0 & 1 & 0 & 0 & 0 & 0 & 0 & 0 \\ 0 & 0 & 1 & 1 & 0 & 1 & 0 & 0 & 0 & 1 & 0 & 0 & 0 & 0 & 0 \\ 0 & 0 & 0 & 1 & 1 & 0 & 1 & 0 & 0 & 0 & 1 & 0 & 0 & 0 & 0 \\ 0 & 0 & 0 & 0 & 1 & 1 & 0 & 1 & 0 & 0 & 0 & 1 & 0 & 0 & 0 \\ 0 & 0 & 0 & 0 & 0 & 1 & 1 & 0 & 1 & 0 & 0 & 0 & 1 & 0 & 0 \\ 0 & 0 & 0 & 0 & 0 & 0 & 1 & 1 & 0 & 1 & 0 & 0 & 0 & 1 & 0 \\ 0 & 0 & 0 & 0 & 0 & 0 & 0 & 1 & 1 & 0 & 1 & 0 & 0 & 0 & 1 \\ 1 & 0 & 0 & 0 & 0 & 0 & 0 & 0 & 1 & 1 & 0 & 1 & 0 & 0 & 0 \\ 0 & 1 & 0 & 0 & 0 & 0 & 0 & 0 & 0 & 1 & 1 & 0 & 1 & 0 & 0 \\ 0 & 0 & 1 & 0 & 0 & 0 & 0 & 0 & 0 & 0 & 1 & 1 & 0 & 1 & 0 \\ 0 & 0 & 0 & 1 & 0 & 0 & 0 & 0 & 0 & 0 & 0 & 1 & 1 & 0 & 1 \\ 1 & 0 & 0 & 0 & 1 & 0 & 0 & 0 & 0 & 0 & 0 & 0 & 1 & 1 & 0 \\ 0 & 1 & 0 & 0 & 0 & 1 & 0 & 0 & 0 & 0 & 0 & 0 & 0 & 1 & 1 \\ 1 & 0 & 1 & 0 & 0 & 0 & 1 & 0 & 0 & 0 & 0 & 0 & 0 & 0 & 1\end{matrix}\right]$

In another example, the binary base matrix may be determined based on the primitive polynomial of the Galois field.

Exemplarily, the binary base matrix may be determined based on the primitive polynomial of the Galois field GF(2^{m}) with prime 2. The primitive polynomial of GF(2^{m}) may be expressed as P(x) = p₀ + p₁x + p₂x² + ··· + pₘ₋₁x^{m-1} + x^{m}, pᵢ ∈ {0,1}, 0 ≤ i < m. Thus, based on the coefficient set {p₀, p₁, p₂, ... , pₘ₋₁, 1} of the primitive polynomial, an n*n non-full-rank circulant matrix, i.e., the binary base matrix, may be constructed. n = (2^{m} - 1) _{*} t, t is a positive integer. It can be derived that, n is a positive integer multiple of 2^{m} - 1, and first m+1 elements of a row vector of the first row of the circulant matrix are determined by the coefficient set, and the remaining n-m-1 elements are 0 elements. Moreover, the rank of the obtained binary base matrix is n-m. The binary base matrix also has a non-full-rank circulant matrix structure.

For example, in a case of m=4, the primitive polynomial of the Galois field GF(2⁴) with prime 2 is P(x) = 1 + x + x⁴, its coefficient set is {1 1 0 0 1}, which is used to construct a non-full-rank circulant matrix with a dimension of 15*15 as the binary base matrix B, n = 2^{m} - 1 = 2⁴ - 1 = 15, and the rank of the binary base matrix B is 11. Exemplarily, the binary base matrix B may be expressed as: $B = \left[\begin{matrix}1 & 1 & 0 & 0 & 1 & 0 & 0 & 0 & 0 & 0 & 0 & 0 & 0 & 0 & 0 \\ 0 & 1 & 1 & 0 & 0 & 1 & 0 & 0 & 0 & 0 & 0 & 0 & 0 & 0 & 0 \\ 0 & 0 & 1 & 1 & 0 & 0 & 1 & 0 & 0 & 0 & 0 & 0 & 0 & 0 & 0 \\ 0 & 0 & 0 & 1 & 1 & 0 & 0 & 1 & 0 & 0 & 0 & 0 & 0 & 0 & 0 \\ 0 & 0 & 0 & 0 & 1 & 1 & 0 & 0 & 1 & 0 & 0 & 0 & 0 & 0 & 0 \\ 0 & 0 & 0 & 0 & 0 & 1 & 1 & 0 & 0 & 1 & 0 & 0 & 0 & 0 & 0 \\ 0 & 0 & 0 & 0 & 0 & 0 & 1 & 1 & 0 & 0 & 1 & 0 & 0 & 0 & 0 \\ 0 & 0 & 0 & 0 & 0 & 0 & 0 & 1 & 1 & 0 & 0 & 1 & 0 & 0 & 0 \\ 0 & 0 & 0 & 0 & 0 & 0 & 0 & 0 & 1 & 1 & 0 & 0 & 1 & 0 & 0 \\ 0 & 0 & 0 & 0 & 0 & 0 & 0 & 0 & 0 & 1 & 1 & 0 & 0 & 1 & 0 \\ 0 & 0 & 0 & 0 & 0 & 0 & 0 & 0 & 0 & 0 & 1 & 1 & 0 & 0 & 1 \\ 1 & 0 & 0 & 0 & 0 & 0 & 0 & 0 & 0 & 0 & 0 & 1 & 1 & 0 & 0 \\ 0 & 1 & 0 & 0 & 0 & 0 & 0 & 0 & 0 & 0 & 0 & 0 & 1 & 1 & 0 \\ 0 & 0 & 1 & 0 & 0 & 0 & 0 & 0 & 0 & 0 & 0 & 0 & 0 & 1 & 1 \\ 1 & 0 & 0 & 1 & 0 & 0 & 0 & 0 & 0 & 0 & 0 & 0 & 0 & 0 & 1\end{matrix}\right]$

As another example, in a case of m=3, the primitive polynomial of the Galois field GF(2³) with prime 2 is P(x) = 1 + x + x³, its coefficient set is {1 1 0 1}, which is used to construct a non-full-rank circulant matrix with a dimension of 14*14 as the binary base matrix B, n = (2^{m} - 1) _{*} 2 = (2³ - 1) _{*} 2 = 14, and the rank of the binary base matrix B is 11. Exemplarily, the binary base matrix B may be expressed as: $B = \left[\begin{matrix}1 & 1 & 0 & 1 & 0 & 0 & 0 & 0 & 0 & 0 & 0 & 0 & 0 & 0 & 0 \\ 0 & 1 & 1 & 0 & 1 & 0 & 0 & 0 & 0 & 0 & 0 & 0 & 0 & 0 & 0 \\ 0 & 0 & 1 & 1 & 0 & 1 & 0 & 0 & 0 & 0 & 0 & 0 & 0 & 0 & 0 \\ 0 & 0 & 0 & 1 & 1 & 0 & 1 & 0 & 0 & 0 & 0 & 0 & 0 & 0 & 0 \\ 0 & 0 & 0 & 0 & 1 & 1 & 0 & 1 & 0 & 0 & 0 & 0 & 0 & 0 & 0 \\ 0 & 0 & 0 & 0 & 0 & 1 & 1 & 0 & 1 & 0 & 0 & 0 & 0 & 0 & 0 \\ 0 & 0 & 0 & 0 & 0 & 0 & 1 & 1 & 0 & 1 & 0 & 0 & 0 & 0 & 0 \\ 0 & 0 & 0 & 0 & 0 & 0 & 0 & 1 & 1 & 0 & 1 & 0 & 0 & 0 & 0 \\ 0 & 0 & 0 & 0 & 0 & 0 & 0 & 0 & 1 & 1 & 0 & 1 & 0 & 0 & 0 \\ 0 & 0 & 0 & 0 & 0 & 0 & 0 & 0 & 0 & 1 & 1 & 0 & 1 & 0 & 0 \\ 0 & 0 & 0 & 0 & 0 & 0 & 0 & 0 & 0 & 0 & 1 & 1 & 0 & 1 & 0 \\ 0 & 0 & 0 & 0 & 0 & 0 & 0 & 0 & 0 & 0 & 0 & 1 & 1 & 0 & 1 \\ 1 & 0 & 0 & 0 & 0 & 0 & 0 & 0 & 0 & 0 & 0 & 0 & 1 & 1 & 0 \\ 0 & 1 & 0 & 0 & 0 & 0 & 0 & 0 & 0 & 0 & 0 & 0 & 0 & 0 & 1 \\ 1 & 0 & 1 & 0 & 0 & 0 & 0 & 0 & 0 & 0 & 0 & 0 & 0 & 0 & 1\end{matrix}\right]$

In yet another example, the binary base matrix is determined based on a binary cyclic code.

Exemplarily, the binary base matrix is determined by a binary cyclic code of length n1. A code group of the binary cyclic code of length n1 may be (c₀, c₁, ..., cₙ₁₋₂, cₙ₁₋₁), cᵢ ∈ {0, 1}, 0 ≤ i < n1. Thus, a non-full-rank circulant matrix with dimension n*n, i.e., the binary base circulant matrix, may be determined according to the code group. First n1 elements of the row vectors of the first row of the non-full-rank circulant matrix with the dimension n*n are determined by the code group, the remaining (n-n1) elements of the row vectors of the first row are 0 elements, and the remaining row vectors are obtained by cyclically shifting the previous row vector by one position, n≥n1.

For example, a (7, 3) cyclic code is used to determine the binary base matrix. Exemplarily, all code groups of the cyclic code are shown in Table 1 below.

**Table 1**

| Code group index | Information bits | Check bits |
|---|---|---|
| | *c*₀, *c*₁, *c*₂ | *c*₃, *c*₄, *c*₅, *c*₆ |
| 1 | 000 | 0000 |
| 2 | 001 | 0111 |
| 3 | 010 | 1110 |
| 4 | 011 | 1001 |
| 5 | 100 | 1011 |
| 6 | 101 | 1100 |
| 7 | 110 | 0101 |
| 8 | 111 | 0010 |

Except for the all-zero code group with code group index 1, the remaining code groups may all be used to construct a binary base matrix B with a circulant matrix structure. Taking an example of the code group with code group index 5, it is used to construct an 8*8 binary base matrix B, n=8. Exemplarily, the obtained binary base matrix B may be expressed as: $B = \left[\begin{matrix}1 & 0 & 0 & 1 & 0 & 1 & 1 & 0 \\ 0 & 1 & 0 & 0 & 1 & 0 & 1 & 1 \\ 1 & 0 & 1 & 0 & 0 & 1 & 0 & 1 \\ 1 & 1 & 0 & 1 & 0 & 0 & 1 & 0 \\ 0 & 1 & 1 & 0 & 1 & 0 & 0 & 1 \\ 1 & 0 & 1 & 1 & 0 & 1 & 0 & 0 \\ 0 & 1 & 0 & 1 & 1 & 0 & 1 & 0 \\ 0 & 0 & 1 & 0 & 1 & 1 & 0 & 1\end{matrix}\right]$

### (2) Lifting factor

The lifting factor may be a parameter used in NB-LDPC technology to improve error correction performance. In actual implementation, the error correction capability of the NB-LDPC codes may be adjusted by adjusting the size of the lifting factor, thereby satisfying actual communication and data transmission requirements.

Taking an example of a larger lifting factor, the larger lifting factor may provide better error correction performance, but also increases the complexity of encoding and decoding. Therefore, it is necessary to determine an appropriate lifting factor according to actual application scenarios and system requirements.

In some embodiments, the lifting factor is determined based on a number of information columns of the binary base matrix, a number of bits of the information bit sequence, and the order of the NB-LDPC codes. Exemplarily, the lifting factor satisfies the following relationship shown in Formula (1): $Z ∗ {k}_{b} ∗ \left⌊{log}_{2} q\right⌋ \geq K$ Formula (1)

Z is the lifting factor,*k_{b}* is the number of columns of the binary base matrix, q is the order of the NB-LDPC codes, *K* is the number of bits of the information bit sequence, and $\left⌊⋅\right⌋$ represents rounding down.

### (3) Exponent matrix

The exponent matrix may be used to represent the check constraint relationship of the NB-LDPC codes, and may also be understood that the exponent matrix may be used to describe the check matrix of the NB-LDPC codes. Exemplarily, through the exponent matrix, the relationship between various elements in the check matrix of the NB-LDPC codes may be reflected, thereby facilitating the encoding and decoding operations. In some embodiments, the exponent matrix may also be used to describe parameters such as the row weight and column weight of the NB-LDPC codes.

In some embodiments, the exponent matrix includes a first element and a second element, the first element is used to indicate an all-zero square matrix, and the second element is used to indicate a binary circulant square matrix.

Exemplarily, the exponent matrix ${H}_{w} = {h}_{i , j}^{b} \left(0\leq i,j<n\right)$, with the superscript b taking a value of 1 or 2, which may be used to represent the element type. Thus, the first element may be expressed as ${h}_{i , j}^{1}$, which is used to indicate an all-zero square matrix. The second element may be used to represent ${h}_{i , j}^{2}$, which is used to indicate a binary circulant square matrix. Moreover, the dimensions of the all-zero square matrix and the binary circulant matrix are both Z*Z.

In some embodiments, the dimension of the exponent matrix is determined based on the dimension of the binary base matrix, the position of the first element is determined based on the position of an element with a value of 0 in the binary base matrix, and the position of the second element is determined based on the position of an element with a value of 1 in the binary base matrix.

Further, the dimension of the exponent matrix H_{w} may be the same as the dimension of the above binary base matrix, so that the dimension of the exponent matrix H_{w} may be determined based on the dimension of the binary base matrix. Moreover, the position of the first element in the exponent matrix H_{w} may correspond to the position of a 0 element in the binary base matrix, and the position of the second element in the exponent matrix H_{w} may correspond to the position of a 1 element in the binary base matrix. For example, in a case where b_{i,j} = 0 in the base matrix B, ${h}_{i , j}^{b} = {h}_{i , j}^{1}$ in the exponent matrix. In a case where b_{i,j} = 1 In the base matrix B, ${h}_{i , j}^{b} = {h}_{i , j}^{2}$, in the exponent matrix, 0 ≤ i,j < n.

In some embodiments, the row weight and column weight of the binary circulant square matrix are both 1. Exemplarily, the binary circulant square matrix is a cyclic shift matrix of an identity matrix.

In some embodiments, the second element satisfies any one of:
the second element being used to indicate a cyclic shift value of the binary circulant square matrix;
the second element being used to indicate a row vector of a predefined row of the binary circulant square matrix; or
the second element being used to indicate a column index of an element with a value of 1 in a predefined row of the binary circulant square matrix.

In an example, the second element is used to indicate the cyclic shift value of the binary circulant square matrix.

For example, the second element may be a non-negative integer, and the second element is used to indicate the cyclic shift value of the binary circulant square matrix. The cyclic shift value may be used to represent a cyclic shift of the binary circulant square matrix relative to the identity matrix, for example, in a case of ${h}_{i , j}^{2} = 0$, the binary circulant square matrix is the identity matrix. In a case of ${h}_{i , j}^{2} > 0$, the binary circulant square matrix is a ${h}_{i , j}^{2} \left(mod Z\right) - th$ cyclic shift of the identity matrix.

In another example, the second element is used to indicate a row vector of a predefined row of the binary circulant square matrix. The predefined row may be a specific row in the binary circulant square matrix that is predetermined, for example a first row, a last row.

Exemplarily, the second element may be a non-binary number, and the second element may be used to indicate a non-binary representation, such as octal representation, decimal representation, hexadecimal representation, etc., of a row vector of the first row of the binary circulant matrix.

For example, take an example in which the second element ${h}_{i , j}^{2} \left(0\leq i,j<n\right)$ is an octal number, and the predefined row as the first row of the binary circulant square matrix. The row vector of the first row of the binary circulant square matrix is a binary vector.

Thus, the binary vector of the row vectors of the first row of the binary circulant matrix may be expressed as [a₀, a₁, ... , a_{z-1}]. The second element ${h}_{i , j}^{2}$ may be an x-bit octal number ${h}_{i , j}^{2} = {d}_{0} {d}_{1} … , {d}_{x - 1}$, 0 ≤ i < x, 0 ≤ dᵢ ≤ 7, and $x = \left⌈Z/3\right⌉$. Thus, the second element indicating the row vectors of the first row of the binary circulant square matrix may satisfy at least one of Mode 1, Mode 2, or Mode 3.

Mode 1, in a case of x = Z/3, for 0 ≤ i < x, so dᵢ = a_{i*3} * 2² + a_{i*3+1} * 2 + a_{i*3+2}, i.e., after the second element ${h}_{i , j}^{2}$ is converted into a 3x-bit binary number, it corresponds to the row vectors of the first row of the binary circulant square matrix.

Mode 2, in a case of x ≠ Z/3, for 0 ≤ i < x - 1, so dᵢ = a_{i*3} * 2² + a_{i*3+1 *} 2 + a_{i*3+2}. For i = x - 1. and 3x - 3 ≤ j ≤ Z - 1, dₓ₋₁ = Σⱼ aⱼ * 2^{z-j}, i.e., after the second element ${h}_{i , j}^{2}$ is converted into a 3x-bit binary index, the first Z bits from left to right of the second element are the row vectors of the first row of the binary circulant square matrix.

Mode 3, in a case of x *≠* Z/3, for 0 < i ≤ x - 1, so dᵢ = a_{(Z-3x)+3i} * 2² + a_{(Z-3x)+3i+1} * 2 + a_{(Z-3x)+3i+2}. For i=0 and 0 ≤ j < 3 + Z - 3x, so d₀ = Σⱼ aⱼ * 2^{3+Z-3x-1-j}, i.e., after the second element ${h}_{i , j}^{2}$ is converted into a 3x-bit binary index, the last Z bits from left to right are the row vectors of the first row of the binary circulant square matrix.

Exemplarily, in a case where the second element ${h}_{i , j}^{2}$ is an x=2-bit octal number, ${h}_{i , j}^{2} = 10$. The second element may be used to indicate the row vectors of the first row of the binary circulant matrix with Z=4, 5, or 6. For example, in a case of Z=6, based on the above Mode 1, the row vectors of the first row of the binary circulant matrix indicated by the second element ${h}_{i , j}^{2}$ is [0, 0, 1, 0, 0, 0]. In a case of Z=5, based on the above Mode 2, the row vectors of the first row of the binary circulant matrix indicated by the second element ${h}_{i , j}^{2}$ is [0, 0, 1, 0, 0], or based on the above Mode 3, so the row vectors of the first row of the binary circulant matrix indicated by the second element ${h}_{i , j}^{2}$ is [0, 1, 0, 0, 0]. In a case of Z=4, based on the above Mode 2, the row vectors of the first row of the binary circulant matrix indicated by the second element ${h}_{i , j}^{2}$ is [0, 0, 1, 0]. Alternatively, based on the above Mode 3, the row vectors of the first row of the binary circulant matrix indicated by the second element ${h}_{i , j}^{2}$ is [1, 0, 0, 0].

As another example, take an example in which the second element ${h}_{i , j}^{2} \left(0\leq i,j<n\right)$ is a decimal number, and the predefined row is the first row of the binary circulant square matrix. A row vector of the first row of the binary circulant square matrix is a binary vector. The binary vector may be expressed as [a₀, a₁, ... , a_{Z-1}]. The second element ${h}_{i , j}^{2}$ may be an x-digit decimal number ${h}_{i , j}^{2} < {2}^{Z}$. Thus, the second element indicating the row vectors of the first row of the binary circulant square matrix may satisfy at least one of: ${h}_{i , j}^{2} = {a}_{0} + {a}_{1} ∗ 2 + {a}_{2} ∗ {2}^{2} + ⋯ + {a}_{Z - 1} ∗ {2}^{Z - 1} ;$ ${h}_{i , j}^{2} = {a}_{0} {2}^{Z - 1} + {a}_{1} ∗ {2}^{Z - 2} + ⋯ + {a}_{Z - 2} ∗ 2 + {a}_{Z - 1} .$

Exemplarily, in a case where the second element ${h}_{i , j}^{2}$ is a decimal number ${h}_{i , j}^{2} = 4$, the second element indicates a binary circulant matrix with Z=4. Based on ${h}_{i , j}^{2} = {a}_{0} + {a}_{1} ∗ 2 + {a}_{2} ∗ {2}^{2} + ⋯ + {a}_{Z - 1} ∗ {2}^{Z - 1}$, the row vector of the first row of the binary circulant matrix indicated by the second element ${h}_{i , j}^{2}$ is [0, 0, 1, 0]. Alternatively, based on ${h}_{i , j}^{2} = {a}_{0} {2}^{Z - 1} + {a}_{1} ∗ {2}^{Z - 2} + ⋯ + {a}_{Z - 2} ∗ 2 + {a}_{Z - 1}$, the row vector of the first row of the binary circulant matrix indicated by the second element ${h}_{i , j}^{2}$ is [0, 1, 0, 0].

As yet another example, take an example in which the second element ${h}_{i , j}^{2} \left(0\leq i,j<n\right)$ is a hexadecimal number, and the predefined row is the first row of the binary circulant square matrix. The row vector of the first row of the binary circulant square matrix is a binary vector. The binary vector may be expressed as [a₀, a₁, ... , a_{z-1}]. The second element ${h}_{i , j}^{2}$ may be an x-digit hexadecimal number ${h}_{i , j}^{2} = {d}_{0} {d}_{1} … {d}_{x - 1}$ , 0 ≤ i < x, 0 ≤ dᵢ ≤ 15, and $x = \left⌈Z/4\right⌉$. Thus, the second element indicating the row vector of the first row of the binary circulant square matrix may satisfy at least one of Mode 4, Mode 5, or Mode 6:
Mode 4, in a case of x = Z/4, for 0 ≤ i < x, so dᵢ = a₄ᵢ * 2³ + a₄ᵢ₊₁ * 2² + a₄ᵢ₊₂ * 2 + a₄ᵢ₊₃, i.e., after the second element ${h}_{i , j}^{2}$ is converted into a 4x-bit binary number, it corresponds to the row vector of the first row of the binary circulant square matrix.

Mode 5, in a case of x ≠ Z/4, for 0 ≤ i < x - 1, so dᵢ = a₄i * 2³ + a₄ᵢ₊₁ * 2² + a₄ᵢ₊₂ * 2 + a_{4i+3·} For i = x - 1 and 4x - 4 ≤ j ≤ Z - 1, so dₓ₋₁ = Σⱼ aⱼ * 2^{Z-j}, i.e., after the second element ${h}_{i , j}^{2}$ is converted into a 4x-bit binary number, the first Z bits from left to right of the second element are the row vectors of the first row of the binary circulant square matrix.

Mode 6, in a case of x ≠ Z/4, for 0 < i ≤ x - 1, so dᵢ = a_{(Z-4x)+4i} * 2³ + a_{(Z-4x)+4i+1} * 2² + a_{(Z-4x)+4i+2} * 2 + a_{(Z-4x)+4i+3}. For i=0 and 0 ≤ j < 4 + Z - 4x, so d₀ = Lⱼ aⱼ * 2^{4+Z-4x-1-j}, i.e., after the second element ${h}_{i , j}^{2}$ is converted into a 4x-bit binary number, the last Z bits from left to right of the second element are the row vectors of the first row of the binary circulant matrix.

Exemplarily, in a case where the second element is an x=2-digit hexadecimal number, ${h}_{i , j}^{2} = 10$. The second element may be used to indicate the row vectors of the first row of the binary circulant matrix with Z=5, 6, 7, or 8. For example, in a case of Z=8, based on the above Mode 4, the row vector of the first row of the binary circulant matrix indicated by the second element ${h}_{i , j}^{2}$ is [0, 0, 0, 1, 0, 0, 0, 0]. For example, in a case of Z=7, based on the above Mode 5, the row vector of the first row of the binary circulant matrix indicated by the second element ${h}_{i , j}^{2}$ is [0, 0, 0, 1, 0, 0, 0]. Alternatively, based on the above Mode 6, the row vector of the first row of the binary circulant matrix indicated by the second element ${h}_{i , j}^{2}$ is [0, 0, 1, 0, 0, 0, 0]. For example, in a case of Z=6, based on the above Mode 5, the row vector of the first row of the binary circulant matrix indicated by the second element ${h}_{i , j}^{2}$ is [0, 0, 0, 1, 0, 0]. Alternatively, based on the above Mode 6, the row vector of the first row of the binary circulant matrix indicated by the second element ${h}_{i , j}^{2}$ is [0, 1, 0, 0, 0, 0]. For example, in a case of Z=5, based on the above Mode 5, the row vector of the first row of the binary circulant matrix indicated by the second element ${h}_{i , j}^{2}$ is [0, 0, 0, 1, 0]. Alternatively, based on the above Mode 6, the row vectors of the first row of the binary circulant matrix indicated by the second element ${h}_{i , j}^{2}$ is [1, 0, 0, 0, 0].

In yet another example, the second element is used to indicate a column index of an element with a value of 1 in a predefined row of the binary circulant square matrix.

Exemplarily, the second element may be a non-empty non-negative integer set, and a plurality of non-negative integers in the set respectively indicate column indices of a plurality of 1 elements in the first row of the binary circulant matrix.

For example, the second element ${h}_{i , j}^{2} \left(0\leq i,j<n\right)$ in the exponent matrix is a non-empty non-negative integer set B = {b₁, b₂, ... , b_{γ}}, γ ≥ 1, and for 1 ≤ i < j ≤ γ, 0 ≤ bᵢ < bⱼ ≤ Z - 1holds. Moreover, the row vectors of the first row of the binary circulant square matrix are a binary vector, and the binary vector may be expressed as [a₀, a₁, ... , a_{Z-1}]; for 0 ≤ i < Z, in a case of i ∈ B, aᵢ = 1, alternatively, in a case of i ∉ B, aᵢ = 0.

And, in a case where the row weight and column weight of the binary circulant square matrix are 1, the second element ${h}_{i , j}^{2} \left(0\leq i,j<n\right)$ is a non-empty non-negative integer set B = {b}, 0 ≤ b ≤ Z - 1. And, the row vector of the first row of the binary circulant square matrix is a binary vector, which may be expressed as [a₀, a₁, ... , a_{Z-1]}, then for 0 ≤ i < Z, in a case of i = b, aᵢ = 1. In a case of i ≠ b, aᵢ = 0.

For example, in a case of Z=3, and the second element ${h}_{i , j}^{2} \left(0\leq i,j<n\right)$ is a non-empty non-negative integer set B = {2}, the row vector of the first row of the binary circulant square matrix indicated by the second element is [0, 0, 1].

In some embodiments, the row weight and column weight of the binary circulant square matrix are both greater than 1. Exemplarily, the row weight and column weight of the binary circulant square matrix indicated by part of the second elements are 1, and the row weight and column weight of the binary circulant matrix indicated by part of the second elements are greater than 1.

Thus, the second element in the exponent matrix indicating the binary circulant square matrix may satisfy any one of:
the second element being used to indicate a row vector of a predefined row of the binary circulant square matrix; or
the second element being used to indicate a column index of an element with a value of 1 in a predefined row of the binary circulant square matrix.

In an example, the second element is used to indicate a row vector of the predefined row of the binary circulant square matrix. The predefined row may be a specific row in the binary circulant square matrix that is predetermined, for example, a first row, a last row.

Exemplarily, the second element may be a non-binary number, and the second element may be used to indicate a non-binary representation of the row vector of the first row of the binary circulant matrix, such as octal representation, decimal representation, hexadecimal representation, etc., and reference may be made to the above detailed description about the second element as a non-binary number, which will not be repeated herein.

In another example, the second element is used to indicate a column index of an element with a value of 1 in a predefined row of the binary circulant square matrix.

Exemplarily, the second element may be a non-empty non-negative integer set, and a plurality of non-negative integers in the set respectively indicate column indices of a plurality of 1 elements in the first row of the binary circulant matrix. That is, the second element ${h}_{i , j}^{2} \left(0\leq i,j<n\right)$ in the exponent matrix is a non-empty non-negative integer set B = {b₁, b₂, ... b_{γ}},γ ≥ 1, and for 1 ≤ i < j ≤ γ, 0 ≤ bᵢ < bⱼ ≤ Z - 1. The row vector of the first row of the binary circulant square matrix is a binary vector, and the binary vector may be expressed as [a₀, a₁, ... , a_{Z-1}]. For 0 ≤ i < Z, in a case of i ∈ B, aᵢ = 1. Alternatively, in a case of i ∉ B, aᵢ = 0. For example, in a case of Z=4, and the second element ${h}_{i , j}^{2} \left(0\leq i,j<n\right)$ is a non-empty non-negative integer set B = {0, 2}, the row vector of the first row of the binary circulant square matrix indicated by the second element is [1, 0, 1, 0].

### (4) Binary extension matrix

The binary extension matrix may be used to describe the check constraint relationship of the NB-LDPC codes, and the binary extension matrix may also be understood to be used to describe the check matrix of the NB-LDPC codes, for example, to describe the structural characteristics of the check matrix. In some embodiments, the complete parity check matrix may be quickly generated through the binary extension matrix, thereby reducing the computational complexity.

In some embodiments, the binary extension matrix is determined based on the exponent matrix and the lifting factor. Exemplarily, the binary extension matrix may be obtained by hashing the exponent matrix based on the lifting factor.

The first element in the exponent matrix is expanded into an all-zero square matrix based on the lifting factor, and the second element in the exponent matrix is expanded into a binary circulant square matrix based on the lifting factor.

Exemplarily, the first element in the exponent matrix may be expanded into an all-zero square matrix with a dimension of Z*Z, and the second element in the exponent matrix may be expanded into a binary circulant square matrix with a dimension of Z*Z. Thus, the dimension of the binary extension matrix is (n*Z) *(n*Z), that is, the binary extension matrix may be represented as being composed of n*n block matrices with a dimension of Z*Z. For example, the binary extension matrix Hb is as follows: $Hb = \left[\begin{matrix}{P}^{{h}_{0 , 0}^{b}} & {P}^{{h}_{0 , 1}^{b}} & {P}^{{h}_{0 , 2}^{b}} & … & {P}^{{h}_{0 , n - 1}^{b}} \\ {P}^{{h}_{1 , 0}^{b}} & {P}^{{h}_{1 , 1}^{b}} & {P}^{{h}_{1 , 2}^{b}} & … & {P}^{{h}_{1 , n - 1}^{b}} \\ ⋮ & ⋮ & ⋮ & ⋱ & ⋮ \\ {P}^{{h}_{n - 1 , 0}^{b}} & {P}^{{h}_{n - 1 , 1}^{b}} & {P}^{{h}_{n - 1 , 2}^{b}} & … & {P}^{{h}_{n - 1 , n - 1}^{b}}\end{matrix}\right] = {P}^{{H}_{w}}$

P is an all-zero square matrix or a binary circulant square matrix with a dimension of Z*Z, and P may be determined based on the element ${h}_{i , j}^{b}$ of the exponent matrix in the superscript. Exemplarily, in a case where ${h}_{i , j}^{b}$ is the first element ${h}_{i , j}^{1}$, P is an all-zero square matrix with a dimension of Z*Z, or in a case where ${h}_{i , j}^{b}$ is the second element ${h}_{i , j}^{2}$, P is a binary circulant square matrix with a dimension of Z*Z indicated by ${h}_{i , j}^{2}$.

### (5) Parity check matrix

The parity check matrix may be used to represent the check constraint relationship of the NB-LDPC codes. Exemplarily, the parity check matrix is a matrix describing the linear correlation that codewords are required to satisfy, which may be used to determine whether a specific vector is a codeword, and is also used in decoding algorithms. The rows of the parity check matrix are the coefficients of the parity check equations, representing how some digits in each codeword may be linearly combined to equal zero.

In some embodiments, a number of non-zero elements in the parity check matrix is determined based on a number of non-zero elements in the binary extension matrix, and positions of the non-zero elements in the parity check matrix are determined based on positions of the non-zero elements in the binary extension matrix.

Exemplarily, a dimension of the parity check matrix Hq is equal to a dimension of the binary extension matrix Hb, that is, the parity check matrix Hq may also be composed of n*n block matrices with a dimension of Z*Z, so the number of non-zero elements in the parity check matrix is determined based on the number of non-zero elements in the binary extension matrix. In addition, the positions of the non-zero elements in Hq and Hb are also the same, so the positions of the non-zero elements in the parity check matrix are determined based on the positions of the non-zero elements in the binary extension matrix. For example, the non-zero elements in the binary extension matrix Hb are 1 elements, while the non-zero elements in the parity check matrix Hq are non-zero elements in a q-order Galois Field GF(q).

In some embodiments, the parity check matrix satisfies any one of:
all non-zero elements in any one of circulant square matrices of the parity check matrix being the same;
there being different non-zero elements in at least one circulant square matrix of the parity check matrix;
all non-zero elements in any one of columns of elements of the parity check matrix being the same; or
there being different non-zero elements in at least one column of elements of the parity check matrix.

In some embodiments, the values of the non-zero elements in the parity check matrix are determined based on at least one of:
the binary base matrix;
the binary extension matrix;
a candidate set, where the candidate set includes non-binary element candidate vectors with a plurality of lengths;
a non-zero non-binary element vector;
a primitive element of a Galois field corresponding to the order of the NB-LDPC codes;
the dimension of the binary base matrix; or
the lifting factor.

It should be noted that, in the technical solutions provided in the present disclosure, the values of the non-zero elements in the parity check matrix may be determined based on at least one of the above binary base matrix, the binary extension matrix, the candidate set, the non-zero non-binary element vector, the primitive element of the Galois field corresponding to the order of the NB-LDPC codes, the dimension of the binary base matrix, or the lifting factor. Further, the binary extension matrix is determined based on the exponent matrix and the lifting factor. That is, when performing NB-LDPC code encoding, it is unnecessary to store the parity check matrix, and only at least one of the above binary base matrix, the exponent matrix, the candidate set, the non-zero non-binary element vector, the primitive element of the Galois field corresponding to the order of the NB-LDPC codes, the dimension of the binary base matrix, or the lifting factor is required to be stored, thereby reducing the storage space required in the NB-LDPC code encoding process.

In an implementation, the values of the non-zero elements in the parity check matrix Hq may be determined based on the binary base matrix B, the candidate set C, and the non-zero non-binary element vector L.

Exemplarily, the candidate set C may be a set of non-binary element candidate vectors with different lengths. For example, C = {C_{dc}}(dc > 0), C_{dc}is a set of non-binary element candidate vectors with a length of dc, and cᵢ = [c_{i,0}, c_{i,1}, ... , c_{i,dc-1}](0 ≤ i < |C_{dc}|, 0 ≤ j < dc, 0 < c_{i,j} < q). The non-binary element vector L may be composed of q-1 non-zero elements in a Galois field GF(q),L = [l₀, l₁, ..., l_{q-2}] and 0 < lᵢ < q;when i ≠ j and 0 ≤ i,j < q - 1, lᵢ ≠ lⱼ.

Exemplarily, the process of determining the parity check matrix based on the binary base matrix, the candidate set, and the non-zero non-binary element vector may be, for example, implemented as the S11 to S17 as follows:
In S11, an initialization coefficient vector t, an indicator variable idx=0, and a row index i=0 are determined.

An all-zero vector with a dimension of 1*n is used as the initialization coefficient vector t.

In S12, a non-binary vector **u** is determined.

The row weight of the i-th row of the binary base matrix B may be denoted as dc, so that a non-binary element vector set *C_{dc}* with a length of dc may be determined from the candidate set C, further, the idx(mod *C_{dc}*)-th candidate vector |*C_{dc}*| may be determined from*c_{idx}*, and the candidate vector *c_{idx}* is cyclically shifted by idx bits (the present disclosure takes right cyclic shift as an example), to obtain the non-binary vector **u.**

In S13. **u** is updated to obtain an updated non-binary vector **u.**

The non-binary vector **u** is multiplied by the idx (mod q-1)-th non-binary element in the non-zero non-binary element vector L to update the non-binary vector **u, u = *u*** * *L(idx(mod q -* 1)), where "*" represents Galois field multiplication.

In S14, **t is** updated based on the updated non-binary vector **u,** to obtain an updated coefficient vector **t.**

The coefficient vector **t** is updated, *t(1,B(i,:) ==* 1) = ***u*,** and B (i,:)==1 represents the column index of a 1 element in the i-th row of the base matrix B.

In S15, an i-th row block matrix Hqᵢ of the parity check matrix Hq is determined according to the coefficient vector **t.**

According to the coefficient vector **t,** 1 elements in the i-th row block matrix of the binary extension matrix Hb are assigned as values of non-zero elements in GF(q), to obtain the i-th row block matrix *Hqᵢ* of the parity check matrix Hq, ${Hq}_{i} = t ∗ \left[{P}^{{h}_{i , j}^{b}}\right] = \left[{t}_{0}{P}^{{h}_{i , 0}^{b}},{t}_{1}{P}^{{h}_{i , 1}^{b}},…,{t}_{n - 1}{P}^{{h}_{i , n - 1}^{b}}\right] , 0 \leq j < n$*.*

In S16, the vector **t** is updated to an all-zero vector with a dimension of 1*n, and the row index i is updated to i+1 and the indicator variable idx is updated to idx+1.

In S17, the above S12 to S16 are repeatedly performed until the non-binary assignment of the block matrices of n rows of the binary extension matrix is completed, to obtain the parity check matrix Hq.

In some embodiments, all non-zero elements in a same circulant matrix of the parity check matrix of NB-LDPC are the same.

Exemplarily, take an example in which the binary base matrix B is a full "1" matrix with a dimension of 2*2, the lifting factor Z=4, and the binary extension matrix Hb is composed of 2*2 block matrices with a dimension of 4*4. For the description of the candidate set C and the non-zero non-binary element vector L, reference may be made to the above implementation. Hb may be expressed as: $Hb = \left[\begin{matrix}0 & 1 & 1 & 0 & 0 & 0 & 1 & 1 \\ 0 & 0 & 1 & 1 & 1 & 0 & 0 & 1 \\ 1 & 0 & 0 & 1 & 1 & 1 & 0 & 0 \\ 1 & 1 & 0 & 0 & 0 & 1 & 1 & 0 \\ 0 & 1 & 0 & 0 & 0 & 1 & 0 & 0 \\ 0 & 0 & 1 & 0 & 0 & 0 & 1 & 0 \\ 0 & 0 & 0 & 1 & 0 & 0 & 0 & 1 \\ 1 & 0 & 0 & 0 & 1 & 0 & 0 & 0\end{matrix}\right]$

Based on the above S11 to S17, the parity check matrix Hq may be obtained as follows: $Hq = \left[\begin{matrix}0 & 3 & 3 & 0 & 0 & 0 & 10 & 10 \\ 0 & 0 & 3 & 3 & 10 & 0 & 0 & 10 \\ 3 & 0 & 0 & 3 & 10 & 10 & 0 & 0 \\ 3 & 3 & 0 & 0 & 0 & 10 & 10 & 0 \\ 0 & 12 & 0 & 0 & 0 & 2 & 0 & 0 \\ 0 & 0 & 12 & 0 & 0 & 0 & 2 & 0 \\ 0 & 0 & 0 & 12 & 0 & 0 & 0 & 2 \\ 12 & 0 & 0 & 0 & 2 & 0 & 0 & 0\end{matrix}\right]$

All non-zero elements in the same circulant matrix in the parity check matrix of NB-LDPC are the same.

In another implementation, the values of the non-zero elements in the parity check matrix Hq may be determined based on the binary extension matrix Hb, the candidate set C, and the non-zero non-binary element vector L.

Exemplarily, the candidate set C may be a set of non-binary element candidate vectors with different lengths. For example, *C =* {*C_{dc}*}(*dc > 0), C_{dc}*is a set of non-binary element candidate vectors with a length of dc, and *cᵢ* = [*c*_{*i,*0}, *c*_{*i,*1}, ..., *c*_{*i,dc*-1}] (0 ≤ *i* < |*C_{dc}*|, 0 ≤ *j < dc,* 0 *< c_{i,j} < q*). The non-binary element vector L may be composed of q-1 non-zero elements in a Galois field GF(q), *L =* [*l*₀, *l*₁, ... , *l*_{*q*-2}] and 0 < *lᵢ* < *q*; when *i* ≠ *j* and 0 ≤ *i,j* < *q* - 1, *lᵢ* ≠ *lⱼ.*

In an example, the process of determining the parity check matrix based on the binary extension matrix Hb, the candidate set C, and the non-zero non-binary element vector L may be, for example, implemented as S2A1 to S2A7 as follows:
In S2A1: an initialization indicator variable idx=0 and a row index i=0 are determined.
In S2A2: a non-binary vector **u** is determined.

For the (i*Z)-th row to the ((i+1)*Z-1)-th row of the binary extension matrix Hb, which may be composed of n block matrices with a dimension of Z*Z, expressed as ${Hb}_{i} = \left[{P}^{{h}_{i , j}^{b}}\right] \left(0\leq j<n\right)$*.* P is an all-zero square matrix with a dimension of Z*Z indicated by the first element ${h}_{i , j}^{1}$ in the exponent matrix, or a binary circulant square matrix with a dimension of Z*Z indicated by the second element ${h}_{i , j}^{2}$ in the exponent matrix. The row weights of the Z rows of the binary extension matrix Hb are all dc, and the (idx (mod |*C_{dc}*|))-th candidate vector ***c**_{ídx}* is selected from the non-binary element vector set *C_{dc}* with a length of dc in the candidate set C, and the candidate vector is cyclically shifted by idx bits (the present disclosure takes right cyclic shift as an example), to obtain the non-binary vector **u.**

In S2A3, the non-binary vector **u** is updated.

Exemplarily, the non-binary vector **u** may be multiplied by the (idx (mod q-1))-th non-binary element in the non-zero non-binary element vector L, to update the non-binary vector **u, u = *u*** * *L(idx),* where "*" represents Galois field multiplication.

In S2A4, a 0-th row in the i-th row block matrix of the parity check matrix, i.e., the (i*Z)-th row of the parity check matrix, is determined.

Exemplarily, 1 elements in the 0-th row of the block matrix of the i-th row of the binary extension matrix Hb may be assigned as values of non-zero elements in GF(q) according to the non-binary vector **u,** to obtain the 0-th row in the block matrix of the i-th row of the parity check matrix, i.e., the i*Z-th row of the parity check matrix. Hq(i*Z, Hb(i*Z,:)==1)=**u,** Hb(i*Z,:)==1 represents the column index of a 1 element in the i*Z-th row of the binary extension matrix Hb.

In S2A5, the 1-st row to the (Z-1)-th row of the block matrix of the i-th row of the parity check matrix are determined.

Exemplarily, 1 elements in the 1-st row to the (Z-1)-th row of the block matrix of the i-th row of the binary extension matrix Hb may be assigned as values of the non-zero elements in GF(q), to obtain the 1-st row to the (Z-1)-th row in the i-th row block matrix of the parity check matrix, and a row vector of the k-th row in the block matrix of the i-th row is a one cyclic shift of a row vector of the (k-1)-th row, 1≤k<Z.

In S2A6, the row index i is updated to i+1 and the indicator variable idx is updated to idx+1.

In S2A7, the above S2A2 to S2A6 are repeatedly performed until the non-binary assignment of the block matrices with n*Z rows of the binary extension matrix is completed, to obtain the parity check matrix Hq.

In some embodiments, there are different non-zero elements in at least one circulant matrix of the parity check matrix of NB-LDPC.

It should be noted that, in a case where the binary circulant matrix indicated by the second element in the exponent matrix has a row weight and column weight greater than or equal to 1, i.e., the row weight and column weight of the binary circulant matrix indicated by a part of second elements are 1, and the row weight and column weight of the binary circulant matrix indicated by a part of second elements are greater than 1, after performing non-binary assignment on the binary extension matrix according to the method for determining the values of the non-zero elements in the parity check matrix Hq, all non-zero elements in the binary circulant square matrix with row weight and column weight equal to 1 are the same, whereas the non-zero elements in the binary circulant square matrix with row weight and column weight greater than 1 are not all the same.

Exemplarily, taking an example in which the binary extension matrix Hb is composed of 2*2 block matrices with a dimension of 4*4, for the description of the candidate set C and the non-zero non-binary element vector L, reference may be made to the above implementation. Based on the above S2A1 to S2A7, the parity check matrix Hq may be obtained as follows: $Hq = \left[\begin{matrix}0 & 11 & 3 & 0 & 0 & 0 & 14 & 1 \\ 0 & 0 & 11 & 3 & 1 & 0 & 0 & 14 \\ 3 & 0 & 0 & 11 & 14 & 1 & 0 & 0 \\ 11 & 3 & 0 & 0 & 0 & 14 & 1 & 0 \\ 0 & 12 & 0 & 0 & 0 & 2 & 0 & 0 \\ 0 & 0 & 12 & 0 & 0 & 0 & 2 & 0 \\ 0 & 0 & 0 & 12 & 0 & 0 & 0 & 2 \\ 12 & 0 & 0 & 0 & 2 & 0 & 0 & 0\end{matrix}\right]$

There are different non-zero elements in at least one circulant matrix in the parity check matrix of NB-LDPC.

In another example, the process of determining the parity check matrix based on the binary extension matrix Hb, the candidate set C, and the non-zero non-binary element vector L may be, for example, implemented as S2B1 to S2B6 as follows.

In S2B1, an initialization indicator variable idx=0 and a row index k=0 are determined.

In S2B2, a non-binary vector **u** is determined.

For the k-th row of the binary extension matrix Hb, the row weight is dc. Thus, a non-binary element vector set *C_{dc}* with a length of dc may be determined from the candidate set C, and the (idx (mod |*C*_{*dc*l}|))-th candidate vector ***c**_{ídx}* is selected from the set *C_{dc},* and the candidate vector is cyclically shifted by idx bits (the present disclosure takes right cyclic shift as an example), to obtain the non-binary vector **u.**

In S2B3, the non-binary vector **u** is updated.

Exemplarily, the non-binary vector **u** may be multiplied by the (idx(mod q-1))-th non-binary element in the non-zero non-binary element vector L, to update the non-binary vector **u, u = *u* *** *L(idx),* where "*" represents Galois field multiplication.

In S2B4, a k-th row of the parity check matrix is determined.

Exemplarily, 1 elements in the k-th row of the binary extension matrix Hb may be assigned as values of non-zero elements in GF(q) according to the non-binary vector **u,** to obtain the k-th row of the parity check matrix, and Hq (k, Hb(k,:)==1)=u, Hb(k,:)==1 represents the column indices of 1 elements in the k-th row of the binary extension matrix Hb.

In S2B5, the row index k is updated to k+1 and the indicator variable idx is updated to idx+1.

In S2B6, the above S2B2 to S2B5 are repeatedly performed until the non-binary assignment of the block matrices with n*Z rows of the binary extension matrix is completed, to obtain the parity check matrix Hq.

In some embodiments, there are different non-zero elements in at least one circulant matrix of the parity check matrix of NB-LDPC.

Exemplarily, taking an example in which the binary extension matrix Hb is composed of 2*2 block matrices with a dimension of 4*4, for the description of the candidate set C and the non-zero non-binary element vector L, reference may be made to the above implementation. Based on the above S2B1 to S2B6, the parity check matrix Hq may be obtained as follows: $Hq = \left[\begin{matrix}0 & 11 & 3 & 0 & 0 & 0 & 14 & 1 \\ 0 & 0 & 15 & 3 & 2 & 0 & 0 & 5 \\ 13 & 0 & 0 & 4 & 10 & 12 & 0 & 0 \\ 13 & 6 & 0 & 0 & 0 & 10 & 2 & 0 \\ 0 & 14 & 0 & 0 & 0 & 2 & 0 & 0 \\ 0 & 0 & 15 & 0 & 0 & 0 & 11 & 0 \\ 0 & 0 & 0 & 7 & 0 & 0 & 0 & 1 \\ 3 & 0 & 0 & 0 & 9 & 0 & 0 & 0\end{matrix}\right]$

There are different non-zero elements in at least one circulant matrix in the parity check matrix of NB-LDPC.

In yet another implementation, the values of the non-zero elements in the parity check matrix Hq may be determined based on the binary base matrix B, the candidate set C, the non-zero non-binary element vector L, and the primitive element α of a q-order Galois field.

Exemplarily, the candidate set C may be a set of non-binary element candidate vectors with different lengths. For example, C *=* {*C_{dc}*}(*dc > 0), C_{dc}*is a set of non-binary element candidate vectors with a length of dc, and ***c**ᵢ* = [*c*_{*í*,0}, *c*_{*i,*1}, ... , *c*_{*i,dc*-1}](0 ≤ *i* < |*C_{dc}*|, 0 ≤ *j < dc,* 0 *< c_{i,j} < q).* The non-binary element vector L may be composed of q-1 non-zero elements in a q-order Galois field, *L =* [*l*₀, *l*₁, ... , *l*_{*q*-2}] and 0 < *lᵢ < q;* when *i ≠ j and* 0 ≤ *i,j < q -* 1, *l_{í}* ≠ *lⱼ.*

Exemplarily, the process of determining the parity check matrix based on the binary base matrix B, the candidate set C, the non-zero non-binary element vector L, and the primitive element α of a q-order Galois field may be, for example, implemented as S31 to S38 as follows.

In S31, an initialization coefficient vector **t,** an indicator variable idx=0, and a row index i=0 are determined.

An all-zero vector with a dimension of 1*n is used as the initialization coefficient vector **t.**

In S32, a non-binary vector **u** is determined.

The row weight of the i-th row of the binary base matrix B may be expressed as dc, so that a non-binary element vector set *C_{dc}* with a length of dc may be determined from the candidate set C, and the (idx (mod |*C*_{*dc*l}|))-th candidate vector ***c**_{ídx}* is selected from the *C_{dc}*, and the candidate vector ***c**_{ídx}* is cyclically shifted by idx bits (the present disclosure takes right cyclic shift as an example), to obtain the non-binary vector **u.**

In S33, **u** is updated to obtain an updated non-binary vector **u.**

The non-binary vector **u** is multiplied by the (idx(mod q-1))-th non-binary element in the non-zero non-binary element vector L, to update the non-binary vector **u, u *= u*** * *L(idx(mod q -* 1)), where "*" represents Galois field multiplication.

In S34, t is updated based on the updated non-binary vector **u,** to obtain an updated coefficient vector **t.**

The coefficient vector **t** is updated, *t(1,B(i,:)* == 1) = ***u*,** and B(i,:)==1 represents the column indices of 1 elements in the i-th row of the base matrix B.

In S35, a 0-th row of the block matrix *Hqᵢ* of the i-th row of the parity check matrix, i.e., the (i*Z)-th row of the parity check matrix, is determined according to the coefficient vector **t.**

According to the coefficient vector **t,** 1 elements in the 0-th row of the i-th row block matrix of the binary extension matrix Hb are assigned as values of non-zero elements in GF(q), to obtain the 0-th row of the i-th row block matrix of the parity check matrix*Hqᵢ*, i.e., the (i*Z)-th row of the parity check matrix, and $Hq \left(i∗Z,:\right) = t ∗ \left[{P}_{0}^{{h}_{i , j}^{b}}\right] = \left[{t}_{0}{P}_{0}^{{h}_{i , 0}^{b}},{t}_{1}{P}_{0}^{{h}_{i , 1}^{b}},…,{t}_{n - 1}{P}_{0}^{{h}_{i , n - 1}^{b}}\right] , 0 \leq j < n , {P}_{0}^{{h}_{i , j}^{b}}$ represents the row vector of the 0-th row of the block matrix indicated by ${h}_{i , j}^{b}$.

In S36, the 1-st row to the (Z-1)-th row of the i-th row block matrix of the parity check matrix are determined.

1 elements in the 1-st row to the (Z-1)-th row of the i-th row block matrix of the binary extension matrix Hb are all assigned as values of non-zero elements in GF(q), to obtain the 1-st row to the (Z-1)-th row of the i-th row block matrix of the parity check matrix correspondingly.

The row vectors of the k-th row in the i-th row block matrix may be obtained by a cyclic shift after multiplying the row vectors of the (k-1)-th row by the primitive element α of the q-order Galois field, 1≤k<Z.

In S37, the vector **t** is updated to an all-zero vector with a dimension of 1*n, and the row index i is updated to i+1 and the indicator variable idx is updated to idx+1.

In S38, the above S32 to S37 are repeatedly performed until the non-binary assignment of the block matrices with n rows of the binary extension matrix is completed, to obtain the parity check matrix Hq.

Exemplarily, there are different non-zero elements in at least one circulant matrix in the obtained parity check matrix of NB-LDPC.

It should be noted that, after performing non-binary element assignment on the binary circulant square matrix, each row is a cyclic shift after multiplying the row vector of the previous row by the primitive element α of the q-order Galois field, so the non-zero elements in the non-binary circulant matrix are not all the same.

Take an example in which the binary base matrix B is a full "1" matrix with a dimension of 2*2, the lifting factor Z=4, and the binary extension matrix Hb composed of 2*2 block matrices with a dimension of 4*4. For the candidate set C and the non-zero non-binary element vector L, reference may be made to the above implementation. Based on the above S31 to S38, the parity check matrix Hq may be obtained as follows. $Hq = \left[\begin{matrix}0 & 3 & 3 & 0 & 0 & 0 & 10 & 10 \\ 0 & 0 & 6 & 6 & 7 & 0 & 0 & 7 \\ 12 & 0 & 0 & 12 & 14 & 14 & 0 & 0 \\ 11 & 11 & 0 & 0 & 0 & 15 & 15 & 0 \\ 0 & 12 & 0 & 0 & 0 & 2 & 0 & 0 \\ 0 & 0 & 11 & 0 & 0 & 0 & 4 & 0 \\ 0 & 0 & 0 & 5 & 0 & 0 & 0 & 8 \\ 10 & 0 & 0 & 0 & 3 & 0 & 0 & 0\end{matrix}\right]$

There are different non-zero elements in at least one circulant matrix in the parity check matrix of NB-LDPC.

In yet another implementation, the values of the non-zero elements in the parity check matrix Hq may be determined based on the binary extension matrix Hb, the candidate set C, the non-zero non-binary element vector L, and the primitive element α of a q-order Galois field.

Exemplarily, the candidate set C may be a set of non-binary element candidate vectors with different lengths. For example, C *=* {*C_{dc}*}(*dc > 0), C_{dc}*is a set of non-binary element candidate vectors with a length of dc, and ***c**ᵢ* = [*c*_{*í*,0}, *c*_{*i,*1}, ... , *c*_{*i,dc*-1}](0 ≤ *i* < |*C_{dc}*|, 0 ≤ *j < dc,* 0 *< c_{i,j} < q).* The non-binary element vector L may be composed of q-1 non-zero elements in a q-order Galois field, *L =* [*l*₀, *l*₁, ... , *l*_{*q*-2}] and 0 < *lᵢ* < q; when *i ≠ j* and 0 ≤ *i,j* < *q -* 1, *lᵢ* ≠ *lⱼ.*

Exemplarily, the process of determining the parity check matrix based on the binary extension matrix Hb, the candidate set C, the non-zero non-binary element vector L, and the primitive element α of the q-order Galois field may be, for example, implemented as S41 to S47 as follows.

In S41, an initialization indicator variable idx=0 and a row index i=0 are determined.

In S42, a non-binary vector **u** is determined.

For the i*Z-th row to the ((i+1)*(Z-1))-th row of the binary extension matrix Hb, which may be composed of n block matrices with a dimension of Z*Z, expressed as ${Hb}_{i} = \left[{P}^{{h}_{i , j}^{b}}\right] \left(0\leq j<n\right)$*.* The row weights of the Z rows of the binary extension matrix Hb are all dc, and the (idx (mod |*C*_{*dc*l}|))-th candidate vector ***c**_{ídx}* is selected from the non-binary element vector set *C_{dc}* with a length of dc in the candidate set C, and the candidate vector is cyclically shifted by idx bits (the present disclosure takes right cyclic shift as an example), to obtain the non-binary vector **u.**

In S43, the non-binary vector **u** is updated.

Exemplarily, the non-binary vector **u** may be multiplied by the (idx(mod q-1))-th non-binary element in the non-zero non-binary element vector L, to update the non-binary vector **u,** *u* = *u* * *L(idx),* where "*" represents Galois field multiplication.

In S44, a 0-th row in the i-th row block matrix of the parity check matrix, i.e., the (i*Z)-th row of the parity check matrix, is determined.

Exemplarily, 1 elements in the 0-th row of the i-th row block matrix of the binary extension matrix Hb may be assigned as values of non-zero elements in GF(q) according to the non-binary vector **u,** to obtain the 0-th row in the i-th row block matrix of the parity check matrix, i.e., the (i*Z)-th row of the parity check matrix. Hq(i*Z, Hb(i*Z,:)==1)=**u**, Hb(i*Z,:)==1 represents the column indices of 1 elements in the i*Z-th row of the binary extension matrix Hb.

In S45, the 1-st row to the (Z-1)-th row of the i-th row block matrix of the parity check matrix are determined based on α.

Exemplarily, 1 elements in the 1-st row to the (Z-1)-th row of the i-th row block matrix of the binary extension matrix Hb may be assigned as values of non-zero elements in GF(q), to obtain the 1-st row to the (Z-1)-th row in the i-th row block matrix of the parity check matrix, and the row vectors of the k-th row in the i-th row block matrix is obtained by a cyclic shift after multiplying the row vectors of the (k-1)-th row by the primitive element α of the q-order Galois field, 1≤k<Z.

In S46, the row index i is updated to i+1 and the indicator variable idx is updated to idx+1.

In S47, the above S42 to S46 are repeatedly performed until the non-binary assignment of the block matrices with n*Z rows of the binary extension matrix is completed, to obtain the parity check matrix Hq.

In some embodiments, there are different non-zero elements in at least one circulant matrix of the parity check matrix of NB-LDPC.

It should be noted that, after performing non-binary element assignment on the binary circulant square matrix, each row is a cyclic shift after multiplying the row vector of the previous row by the primitive element α of the q-order Galois field, so the non-zero elements in the non-binary circulant square matrix are not all the same.

Exemplarily, for the description of the binary extension matrix Hb, the candidate set C, and the non-zero non-binary element vector L, reference may be made to the above implementation, and based on the above S41 to S47, the parity check matrix Hq may be obtained as follows: $Hq = \left[\begin{matrix}0 & 11 & 3 & 0 & 0 & 0 & 14 & 1 \\ 0 & 0 & 5 & 6 & 2 & 0 & 0 & 15 \\ 12 & 0 & 0 & 10 & 13 & 4 & 0 & 0 \\ 7 & 11 & 0 & 0 & 0 & 9 & 8 & 0 \\ 0 & 12 & 0 & 0 & 0 & 2 & 0 & 0 \\ 0 & 0 & 11 & 0 & 0 & 0 & 4 & 0 \\ 0 & 0 & 0 & 5 & 0 & 0 & 0 & 8 \\ 10 & 0 & 0 & 0 & 3 & 0 & 0 & 0\end{matrix}\right]$

There are different non-zero elements in at least one circulant matrix in the parity check matrix of NB-LDPC.

In yet another implementation, the values of the non-zero elements in the parity check matrix Hq may be determined based on the dimension n of the binary base matrix, the candidate set C, and the non-zero non-binary element vector L.

Exemplarily, the candidate set C may be a set of non-binary element candidate vectors with different lengths. For example, C *=* {*C_{dc}*}(*dc > 0), C_{dc}*is a set of non-binary element candidate vectors with a length of dc, and ***c**ᵢ* = [*c*_{*í*,0}, *c*_{*i,*1}, ... , *c*_{*i,dc*-1}] (0 ≤ *i* < |*C_{dc}*|, 0 ≤ *j < dc,* 0 *< c_{i,j} < q).* The non-binary element vector L may be composed of q-1 non-zero elements in a q-order Galois field, *L =* [*l*₀, *l*₁, ..., *l*_{*q-*2}] and 0 < *lᵢ* < q; when *i ≠ j and* 0 ≤ *i,j < q -* 1,*lᵢ* ≠ *lⱼ.*

Exemplarily, the process of determining the parity check matrix based on the dimension n of the binary base matrix, the candidate set C, and the non-zero non-binary element vector L may be, for example, implemented as S51 to S53 as follows.

In S51, a non-binary element vector set *Cₙ* with a length of n is determined from the candidate set C, and a candidate vector ***c**ₙ* is selected from *Cₙ*.

In S52, a non-binary vector **u** is determined.

The candidate vector ***c**ₙ* is multiplied by a non-binary element e in the non-zero non-binary element vector L (for example, a first non-binary element in L), to obtain the non-binary vector **u,** and ***u*** = ***c**ₙ* * *e* is satisfied, where "*" represents Galois field multiplication.

In S53, the binary extension matrix Hb is assigned according to the non-binary vector, to obtain the parity check matrix Hq.

The parity check matrix satisfies $Hq = \left[{u}_{j}{P}^{{h}_{i , j}^{b}}\right] , 0 \leq i , j < n$, 0 ≤ *i,j < n.*

Exemplarily, all non-zero elements in a same circulant matrix in the obtained parity check matrix of NB-LDPC are the same and all non-zero elements in a same column in the obtained parity check matrix of NB-LDPC are the same.

Exemplarily, taking an example in which the dimension n of the binary base matrix is equal to 2, for the description of the candidate set C and the non-zero non-binary element vector L, reference may be made to the above implementation, and based on the above S51 to S53, the parity check matrix Hq may be obtained as follows: $Hq = \left[\begin{matrix}0 & 3 & 3 & 0 & 0 & 0 & 10 & 10 \\ 0 & 0 & 3 & 3 & 10 & 0 & 0 & 10 \\ 3 & 0 & 0 & 3 & 10 & 10 & 0 & 0 \\ 3 & 3 & 0 & 0 & 0 & 10 & 10 & 0 \\ 0 & 3 & 0 & 0 & 0 & 10 & 0 & 0 \\ 0 & 0 & 3 & 0 & 0 & 0 & 10 & 0 \\ 0 & 0 & 0 & 3 & 0 & 0 & 0 & 10 \\ 3 & 0 & 0 & 0 & 10 & 0 & 0 & 0\end{matrix}\right]$

All non-zero elements in the same circulant matrix in the parity check matrix of NB-LDPC are the same and all non-zero elements in the same column in the parity check matrix of NB-LDPC are the same. In yet another implementation, the values of the non-zero elements in the parity check matrix Hq may be determined based on the dimension n of the binary base matrix, the lifting factor Z, the candidate set C, and the non-zero non-binary element vector L.

Exemplarily, the candidate set C may be a set of non-binary element candidate vectors with different lengths. For example, C *=* {*C_{dc}*} (*dc > 0), C_{dc}* is a set of non-binary element candidate vectors with a length of dc, and ***c**ᵢ* = [*c*_{*i*,0}*, c*_{*i*,1}, ..., *c*_{*i,dc*-1}] (0 ≤ *i* < |*C_{dc}*|, 0 ≤ *j < dc,* 0 *< c_{i,j} < q).* The non-binary element vector L may be composed of q-1 non-zero elements in a q-order Galois field, *L =* [*l*₀, *l*₁, *...* , *l*_{*q*-2}] and 0 < *lᵢ* < *q*; when *i* ≠ *j and 0* ≤ *i,j* < *q* - 1, *lᵢ* ≠ *lⱼ.*

Exemplarily, the process of determining the parity check matrix based on the dimension n of the binary base matrix, the lifting factor Z, the candidate set C, and the non-zero non-binary element vector L may be, for example, implemented as S61 to S63 as follows.

In S61, a non-binary element vector set *C_{n*Z}* with a length of n*Z is determined from the candidate set C, and a candidate vector ***c**_{n*Z}* is selected from *C_{n*Z}.*

In S62, a non-binary vector **u** is determined.

The candidate vector ***c**_{n*Z}* is multiplied by a non-binary element e in the non-zero non-binary element vector L (for example, the first non-binary element in L), to obtain the non-binary vector **u,** and u = ***c**_{n*Z *} e* is satisfied, where "*" represents Galois field multiplication.

In S63, the binary extension matrix Hb is assigned according to the non-binary vector, to obtain the parity check matrix Hq.

The parity check matrix satisfies *Hq = **u*** * *Hb =* [*uⱼHb_{i,j}*], 0 ≤ *i,j < n* * *Z. Hb_{i,j}* represents the element at the i-th row and j-th column of the binary extension matrix Hb.

Exemplarily, in the obtained parity check matrix of NB-LDPC, there are different non-zero elements in at least one circulant matrix and all non-zero elements in the same column are the same.

Exemplarily, taking an example in which the dimension n of the binary base matrix is equal to 2 and the lifting factor Z is equal to 4, for the description of the candidate set C and the non-zero non-binary element vector L, reference may be made to the above implementation, and based on the above S61 to S63, the parity check matrix Hq may be obtained as follows: $Hq = \left[\begin{matrix}0 & 15 & 5 & 0 & 0 & 0 & 3 & 1 \\ 0 & 0 & 5 & 5 & 3 & 0 & 0 & 1 \\ 14 & 0 & 0 & 5 & 3 & 2 & 0 & 0 \\ 14 & 15 & 0 & 0 & 0 & 2 & 3 & 0 \\ 0 & 15 & 0 & 0 & 0 & 2 & 0 & 0 \\ 0 & 0 & 5 & 0 & 0 & 0 & 3 & 0 \\ 0 & 0 & 0 & 5 & 0 & 0 & 0 & 1 \\ 14 & 0 & 0 & 0 & 3 & 0 & 0 & 0\end{matrix}\right]$

In the parity check matrix of NB-LDPC, there are different non-zero elements in at least one circulant matrix and all non-zero elements in the same column are the same.

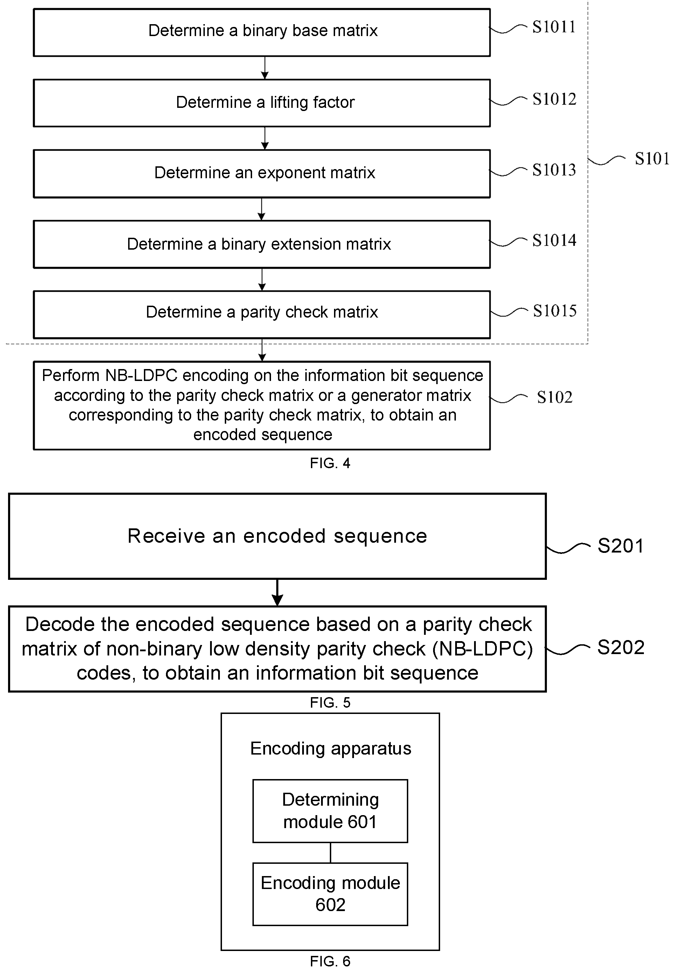

Exemplarily, taking an example in which the to-be-encoded information bit length K=32 bits, the target NB-LDPC codes are 16-order NB-LDPC codes with a code rate of 4/15, i.e., q=16, and the method for determining the parity check matrix shown in S51 to S53 is adopted below, S101 is exemplarily explained. Exemplarily, as shown in FIG. 4, S101 may be implemented as, for example, S1011 to S1015.

In S1011, a binary base matrix is determined.

The binary base matrix *B =* [*b_{i,j}*](0 ≤ *i,j < n)* has a non-full-rank circulant matrix structure. The dimension n*n of B may be determined through preset or via signaling configuration. Taking an example of n=15, the binary base matrix B may be determined by a preset generating set S={0 1 3 7}, and B may be expressed as: $B = \left[\begin{matrix}1 & 1 & 0 & 1 & 0 & 0 & 0 & 1 & 0 & 0 & 0 & 0 & 0 & 0 & 0 \\ 0 & 1 & 1 & 0 & 1 & 0 & 0 & 0 & 1 & 0 & 0 & 0 & 0 & 0 & 0 \\ 0 & 0 & 1 & 1 & 0 & 1 & 0 & 0 & 0 & 1 & 0 & 0 & 0 & 0 & 0 \\ 0 & 0 & 0 & 1 & 1 & 0 & 1 & 0 & 0 & 0 & 1 & 0 & 0 & 0 & 0 \\ 0 & 0 & 0 & 0 & 1 & 1 & 0 & 1 & 0 & 0 & 0 & 1 & 0 & 0 & 0 \\ 0 & 0 & 0 & 0 & 0 & 1 & 1 & 0 & 1 & 0 & 0 & 0 & 1 & 0 & 0 \\ 0 & 0 & 0 & 0 & 0 & 0 & 1 & 1 & 0 & 1 & 0 & 0 & 0 & 1 & 0 \\ 0 & 0 & 0 & 0 & 0 & 0 & 0 & 1 & 1 & 0 & 1 & 0 & 0 & 0 & 1 \\ 1 & 0 & 0 & 0 & 0 & 0 & 0 & 0 & 1 & 1 & 0 & 1 & 0 & 0 & 0 \\ 0 & 1 & 0 & 0 & 0 & 0 & 0 & 0 & 0 & 1 & 1 & 0 & 1 & 0 & 0 \\ 0 & 0 & 1 & 0 & 0 & 0 & 0 & 0 & 0 & 0 & 1 & 1 & 0 & 1 & 0 \\ 0 & 0 & 0 & 1 & 0 & 0 & 0 & 0 & 0 & 0 & 0 & 1 & 1 & 0 & 1 \\ 1 & 0 & 0 & 0 & 1 & 0 & 0 & 0 & 0 & 0 & 0 & 0 & 1 & 1 & 0 \\ 0 & 1 & 0 & 0 & 0 & 1 & 0 & 0 & 0 & 0 & 0 & 0 & 0 & 1 & 1 \\ 1 & 0 & 1 & 0 & 0 & 0 & 1 & 0 & 0 & 0 & 0 & 0 & 0 & 0 & 1\end{matrix}\right]$

The row weight and column weight of the binary base matrix B with a cyclic matrix structure constructed from the preset generation set S={0 1 3 7} are both 4, and its rank is 4.

In S1012, a lifting factor is determined.

Exemplarily, the lifting factor Z may be determined by a number of to-be-encoded information bits K, a number of information columns kb of the binary base matrix, and the order q of the NB-LDPC codes, where Z satisfies $Z ∗ kb ∗ \left⌊{log}_{2} q\right⌋ \geq K$*,* and $\left⌊⋅\right⌋$ represents rounding down.

When K=32 bits, kb=4, and q=16, the lifting factor Z may be 2.

In S1013, an exponent matrix is determined.

Based on the above base matrix B and the lifting factor Z=2, the exponent matrix Hw may be expressed as: $Hw = \left[\begin{matrix}{h}_{0 , 0}^{2} & {h}_{0 , 1}^{2} & {h}_{0 , 2}^{1} & {h}_{0 , 3}^{2} & {h}_{0 , 4}^{1} & {h}_{0 , 5}^{1} & {h}_{0 , 6}^{1} & {h}_{0 , 7}^{2} & {h}_{0 , 8}^{1} & {h}_{0 , 9}^{1} & {h}_{0 , 10}^{1} & {h}_{0 , 11}^{1} & {h}_{0 , 12}^{1} & {h}_{0 , 13}^{1} & {h}_{0 , 14}^{1} \\ {h}_{1 , 0}^{1} & {h}_{1 , 1}^{2} & {h}_{1 , 2}^{2} & {h}_{1 , 3}^{1} & {h}_{1 , 4}^{2} & {h}_{1 , 5}^{1} & {h}_{1 , 6}^{1} & {h}_{1 , 7}^{1} & {h}_{1 , 8}^{2} & {h}_{1 , 9}^{1} & {h}_{1 , 10}^{1} & {h}_{1 , 11}^{1} & {h}_{1 , 12}^{1} & {h}_{1 , 13}^{1} & {h}_{1 , 14}^{1} \\ {h}_{2 , 0}^{1} & {h}_{2 , 1}^{1} & {h}_{2 , 2}^{1} & {h}_{2 , 3}^{1} & {h}_{2 , 4}^{1} & {h}_{2 , 5}^{2} & {h}_{2 , 6}^{1} & {h}_{2 , 7}^{1} & {h}_{2 , 8}^{1} & {h}_{2 , 9}^{2} & {h}_{2 , 10}^{1} & {h}_{2 , 11}^{1} & {h}_{2 , 12}^{1} & {h}_{2 , 13}^{1} & {h}_{2 , 14}^{1} \\ {h}_{3 , 0}^{1} & {h}_{3 , 1}^{1} & {h}_{3 , 2}^{1} & {h}_{3 , 3}^{2} & {h}_{3 , 4}^{2} & {h}_{3 , 5}^{1} & {h}_{3 , 6}^{2} & {h}_{3 , 7}^{1} & {h}_{3 , 8}^{1} & {h}_{3 , 9}^{1} & {h}_{3 , 10}^{2} & {h}_{3 , 11}^{1} & {h}_{3 , 12}^{1} & {h}_{3 , 13}^{1} & {h}_{3 , 14}^{1} \\ {h}_{4 , 0}^{1} & {h}_{4 , 1}^{1} & {h}_{4 , 2}^{1} & {h}_{4 , 3}^{1} & {h}_{4 , 4}^{2} & {h}_{4 , 5}^{2} & {h}_{4 , 6}^{1} & {h}_{4 , 7}^{2} & {h}_{4 , 8}^{1} & {h}_{4 , 9}^{1} & {h}_{4 , 10}^{1} & {h}_{4 , 11}^{2} & {h}_{4 , 12}^{1} & {h}_{4 , 13}^{1} & {h}_{4 , 14}^{1} \\ {h}_{5 , 0}^{1} & {h}_{5 , 1}^{1} & {h}_{5 , 2}^{1} & {h}_{5 , 3}^{1} & {h}_{5 , 4}^{1} & {h}_{5 , 5}^{2} & {h}_{5 , 6}^{2} & {h}_{5 , 7}^{1} & {h}_{5 , 8}^{2} & {h}_{5 , 9}^{1} & {h}_{5 , 10}^{1} & {h}_{5 , 11}^{1} & {h}_{5 , 12}^{1} & {h}_{5 , 13}^{1} & {h}_{5 , 14}^{1} \\ {h}_{6 , 0}^{1} & {h}_{6 , 1}^{1} & {h}_{6 , 2}^{1} & {h}_{6 , 3}^{1} & {h}_{6 , 4}^{1} & {h}_{6 , 5}^{1} & {h}_{6 , 6}^{2} & {h}_{6 , 7}^{2} & {h}_{6 , 8}^{1} & {h}_{6 , 9}^{2} & {h}_{6 , 10}^{1} & {h}_{6 , 11}^{1} & {h}_{6 , 12}^{1} & {h}_{6 , 13}^{2} & {h}_{6 , 14}^{1} \\ {h}_{7 , 0}^{1} & {h}_{7 , 1}^{1} & {h}_{7 , 2}^{1} & {h}_{7 , 3}^{1} & {h}_{7 , 4}^{1} & {h}_{7 , 5}^{1} & {h}_{7 , 6}^{1} & {h}_{7 , 7}^{2} & {h}_{7 , 8}^{2} & {h}_{7 , 9}^{1} & {h}_{7 , 10}^{2} & {h}_{7 , 11}^{1} & {h}_{7 , 12}^{1} & {h}_{7 , 13}^{1} & {h}_{7 , 14}^{2} \\ {h}_{8 , 0}^{2} & {h}_{8 , 1}^{1} & {h}_{8 , 2}^{1} & {h}_{8 , 3}^{1} & {h}_{8 , 4}^{1} & {h}_{8 , 5}^{1} & {h}_{8 , 6}^{1} & {h}_{8 , 7}^{1} & {h}_{8 , 8}^{2} & {h}_{8 , 9}^{2} & {h}_{8 , 10}^{1} & {h}_{8 , 11}^{2} & {h}_{8 , 12}^{1} & {h}_{8 , 13}^{1} & {h}_{8 , 14}^{1} \\ {h}_{9 , 0}^{1} & {h}_{9 , 1}^{2} & {h}_{9 , 2}^{1} & {h}_{9 , 3}^{1} & {h}_{9 , 4}^{1} & {h}_{9 , 5}^{1} & {h}_{9 , 6}^{1} & {h}_{9 , 7}^{1} & {h}_{9 , 8}^{1} & {h}_{9 , 9}^{2} & {h}_{9 , 10}^{2} & {h}_{9 , 11}^{1} & {h}_{9 , 12}^{2} & {h}_{9 , 13}^{1} & {h}_{9 , 14}^{1} \\ {h}_{10 , 0}^{1} & {h}_{10 , 1}^{1} & {h}_{10 , 2}^{2} & {h}_{10 , 3}^{1} & {h}_{10 , 4}^{1} & {h}_{10 , 5}^{1} & {h}_{10 , 6}^{1} & {h}_{10 , 7}^{1} & {h}_{10 , 8}^{1} & {h}_{10 , 9}^{1} & {h}_{10 , 10}^{2} & {h}_{10 , 11}^{2} & {h}_{10 , 12}^{1} & {h}_{10 , 13}^{2} & {h}_{10 , 14}^{1} \\ {h}_{11 , 0}^{1} & {h}_{11 , 1}^{1} & {h}_{11 , 2}^{1} & {h}_{11 , 3}^{2} & {h}_{11 , 4}^{1} & {h}_{11 , 5}^{1} & {h}_{11 , 6}^{1} & {h}_{11 , 7}^{1} & {h}_{11 , 8}^{1} & {h}_{11 , 9}^{1} & {h}_{10 , 10}^{1} & {h}_{10 , 11}^{2} & {h}_{10 , 12}^{2} & {h}_{11 , 13}^{1} & {h}_{11 , 14}^{2} \\ {h}_{12 , 0}^{2} & {h}_{12 , 1}^{1} & {h}_{12 , 2}^{1} & {h}_{12 , 3}^{1} & {h}_{12 , 4}^{2} & {h}_{12 , 5}^{1} & {h}_{12 , 6}^{1} & {h}_{12 , 7}^{1} & {h}_{12 , 8}^{1} & {h}_{12 , 9}^{1} & {h}_{12 , 10}^{1} & {h}_{12 , 11}^{1} & {h}_{12 , 12}^{2} & {h}_{12 , 13}^{2} & {h}_{12 , 14}^{1} \\ {h}_{13 , 0}^{1} & {h}_{13 , 1}^{2} & {h}_{13 , 2}^{1} & {h}_{13 , 3}^{1} & {h}_{13 , 4}^{1} & {h}_{13 , 5}^{2} & {h}_{13 , 6}^{1} & {h}_{13 , 7}^{1} & {h}_{13 , 8}^{1} & {h}_{13 , 9}^{1} & {h}_{13 , 10}^{1} & {h}_{13 , 11}^{1} & {h}_{13 , 12}^{1} & {h}_{13 , 13}^{2} & {h}_{13 , 14}^{2} \\ {h}_{14 , 0}^{2} & {h}_{14 , 1}^{1} & {h}_{14 , 2}^{2} & {h}_{14 , 3}^{1} & {h}_{14 , 4}^{1} & {h}_{14 , 5}^{1} & {h}_{14 , 6}^{2} & {h}_{14 , 7}^{1} & {h}_{14 , 8}^{1} & {h}_{14 , 9}^{1} & {h}_{14 , 10}^{1} & {h}_{14 , 11}^{1} & {h}_{14 , 12}^{1} & {h}_{14 , 13}^{1} & {h}_{14 , 14}^{2}\end{matrix}\right]$

All binary circulant matrices indicated by the second element have a row weight and column weight of 1, thus, the binary circulant matrix is a cyclic shift matrix of the identity matrix.

In some embodiments, the method for the second element in the above exponent matrix to indicate the binary circulant matrix is that: the second element is a non-negative integer to indicate a cyclic shift value of the binary circulant matrix. Exemplarily, the exponent matrix Hw may be expressed as: $Hw = \left[\begin{matrix}0 & 0 & - 1 & 0 & - 1 & - 1 & - 1 & 0 & - 1 & - 1 & - 1 & - 1 & - 1 & - 1 & - 1 \\ - 1 & 0 & 1 & - 1 & 0 & - 1 & - 1 & - 1 & 0 & - 1 & - 1 & - 1 & - 1 & - 1 & - 1 \\ - 1 & - 1 & 0 & 1 & - 1 & 1 & - 1 & - 1 & - 1 & 0 & - 1 & - 1 & - 1 & - 1 & - 1 \\ - 1 & - 1 & - 1 & 1 & 1 & - 1 & 0 & - 1 & - 1 & - 1 & 0 & - 1 & - 1 & - 1 & - 1 \\ - 1 & - 1 & - 1 & - 1 & 0 & 1 & - 1 & 0 & - 1 & - 1 & - 1 & 1 & - 1 & - 1 & - 1 \\ - 1 & - 1 & - 1 & - 1 & - 1 & 0 & 0 & - 1 & 1 & - 1 & - 1 & - 1 & 0 & - 1 & - 1 \\ - 1 & - 1 & - 1 & - 1 & - 1 & - 1 & 0 & 0 & - 1 & 1 & - 1 & - 1 & - 1 & 1 & - 1 \\ - 1 & - 1 & - 1 & - 1 & - 1 & - 1 & - 1 & 0 & 1 & - 1 & 1 & - 1 & - 1 & - 1 & 1 \\ 0 & - 1 & - 1 & - 1 & - 1 & - 1 & - 1 & - 1 & 0 & 1 & - 1 & 1 & - 1 & - 1 & - 1 \\ - 1 & 1 & - 1 & - 1 & - 1 & - 1 & - 1 & - 1 & - 1 & 1 & 0 & - 1 & 1 & - 1 & - 1 \\ - 1 & - 1 & 1 & - 1 & - 1 & - 1 & - 1 & - 1 & - 1 & - 1 & 1 & 0 & - 1 & 1 & - 1 \\ - 1 & - 1 & - 1 & 0 & - 1 & - 1 & - 1 & - 1 & - 1 & - 1 & - 1 & 1 & 0 & - 1 & 0 \\ 1 & - 1 & - 1 & - 1 & 0 & - 1 & - 1 & - 1 & - 1 & - 1 & - 1 & - 1 & 1 & 0 & - 1 \\ - 1 & 0 & - 1 & - 1 & - 1 & 0 & - 1 & - 1 & - 1 & - 1 & - 1 & - 1 & - 1 & 0 & 1 \\ 1 & - 1 & 1 & - 1 & - 1 & - 1 & 0 & - 1 & - 1 & - 1 & - 1 & - 1 & - 1 & - 1 & 0\end{matrix}\right]$

The first element ${h}_{i , j}^{1}$ in the exponent matrix has a fixed value of -1, and indicates an all-zero square matrix with a dimension of Z*Z $\left[\begin{matrix}0 & 0 \\ 0 & 0\end{matrix}\right]$. In a case of Z=2, the value of the second element ${h}_{i , j}^{2}$ in the exponent matrix is 0 or 1; when ${h}_{i , j}^{2} = 0$, the binary circulant matrix indicated by the second element is an identity matrix with a dimension of 2*2 $\left[\begin{matrix}1 & 0 \\ 0 & 1\end{matrix}\right]$; when ${h}_{i , j}^{2} = 1$, the binary circulant matrix indicated by the second element is a one-time cyclic shift of the identity matrix with a dimension of 2*2 $\left[\begin{matrix}0 & 1 \\ 1 & 0\end{matrix}\right]$.

In S1014, a binary extension matrix is determined.

Exemplarily, the binary extension matrix is obtained by hashing the above exponent matrix Hw according to the lifting factor Z=2.

For example, the first element ${h}_{i , j}^{1} = - 1$ in the exponent matrix is expanded into an all-zero square matrix with a dimension of 2*2 $\left[\begin{matrix}0 & 0 \\ 0 & 0\end{matrix}\right]$, and the second element ${h}_{i , j}^{2}$ in the exponent matrix is expanded into a binary circulant matrix with a dimension of 2*2. When ${h}_{i , j}^{2} = 0$, the second element may be expanded into an identity matrix with a dimension of 2*2 $\left[\begin{matrix}1 & 0 \\ 0 & 1\end{matrix}\right]$; when ${h}_{i , j}^{2} = 1$*,* the second element may be expanded into a one-time cyclic shift of the identity matrix with a dimension of 2* 2 $\left[\begin{matrix}0 & 1 \\ 1 & 0\end{matrix}\right]$.

Thus, the dimension of the binary extension matrix is (15*2)*(15*2), which may be composed of 15*15 block matrices with a dimension of 2*2, and the binary extension matrix may be expressed as: $Hb = \left[\begin{matrix}1 & 0 & 1 & 0 & 0 & 0 & 1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 \\ 0 & 1 & 0 & 1 & 0 & 0 & 0 & 1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 \\ 0 & 0 & 1 & 0 & 0 & 1 & 0 & 0 & 1 & 0 & 0 & 0 & 0 & 0 & 0 & 0 & 1 & 0 & 0 & 0 & 0 & 0 & 0 & 0 & 0 & 0 & 0 & 0 & 0 & 0 \\ 0 & 0 & 0 & 1 & 1 & 0 & 0 & 0 & 0 & 1 & 0 & 0 & 0 & 0 & 0 & 0 & 0 & 1 & 0 & 0 & 0 & 0 & 0 & 0 & 0 & 0 & 0 & 0 & 0 & 0 \\ 0 & 0 & 0 & 0 & 1 & 0 & 0 & 1 & 0 & 0 & 0 & 1 & 0 & 0 & 0 & 0 & 0 & 0 & 1 & 0 & 0 & 0 & 0 & 0 & 0 & 0 & 0 & 0 & 0 & 0 \\ 0 & 0 & 0 & 0 & 0 & 1 & 1 & 0 & 0 & 0 & 1 & 0 & 0 & 0 & 0 & 0 & 0 & 0 & 0 & 1 & 0 & 0 & 0 & 0 & 0 & 0 & 0 & 0 & 0 & 0 \\ 0 & 0 & 0 & 0 & 0 & 0 & 0 & 1 & 0 & 1 & 0 & 0 & 1 & 0 & 0 & 0 & 0 & 0 & 0 & 0 & 1 & 0 & 0 & 0 & 0 & 0 & 0 & 0 & 0 & 0 \\ 0 & 0 & 0 & 0 & 0 & 0 & 1 & 0 & 1 & 0 & 0 & 0 & 0 & 1 & 0 & 0 & 0 & 0 & 0 & 0 & 0 & 1 & 0 & 0 & 0 & 0 & 0 & 0 & 0 & 0 \\ 0 & 0 & 0 & 0 & 0 & 0 & 0 & 0 & 1 & 0 & 0 & 1 & 0 & 0 & 1 & 0 & 0 & 0 & 0 & 0 & 0 & 0 & 0 & 1 & 0 & 0 & 0 & 0 & 0 & 0 \\ 0 & 0 & 0 & 0 & 0 & 0 & 0 & 0 & 0 & 1 & 1 & 0 & 0 & 0 & 0 & 1 & 0 & 0 & 0 & 0 & 0 & 0 & 1 & 0 & 0 & 0 & 0 & 0 & 0 & 0 \\ 0 & 0 & 0 & 0 & 0 & 0 & 0 & 0 & 0 & 0 & 1 & 0 & 1 & 0 & 0 & 0 & 0 & 1 & 0 & 0 & 0 & 0 & 0 & 0 & 1 & 0 & 0 & 0 & 0 & 0 \\ 0 & 0 & 0 & 0 & 0 & 0 & 0 & 0 & 0 & 0 & 0 & 1 & 0 & 1 & 0 & 0 & 1 & 0 & 0 & 0 & 0 & 0 & 0 & 0 & 0 & 1 & 0 & 0 & 0 & 0 \\ 0 & 0 & 0 & 0 & 0 & 0 & 0 & 0 & 0 & 0 & 0 & 0 & 1 & 0 & 1 & 0 & 0 & 0 & 0 & 1 & 0 & 0 & 0 & 0 & 0 & 0 & 0 & 1 & 0 & 0 \\ 0 & 0 & 0 & 0 & 0 & 0 & 0 & 0 & 0 & 0 & 0 & 0 & 0 & 1 & 0 & 1 & 0 & 0 & 1 & 0 & 0 & 0 & 0 & 0 & 0 & 0 & 1 & 0 & 0 & 0 \\ 0 & 0 & 0 & 0 & 0 & 0 & 0 & 0 & 0 & 0 & 0 & 0 & 0 & 0 & 1 & 0 & 0 & 1 & 0 & 0 & 0 & 1 & 0 & 0 & 0 & 0 & 0 & 0 & 0 & 1 \\ 0 & 0 & 0 & 0 & 0 & 0 & 0 & 0 & 0 & 0 & 0 & 0 & 0 & 0 & 0 & 1 & 1 & 0 & 0 & 0 & 1 & 0 & 0 & 0 & 0 & 0 & 0 & 0 & 1 & 0 \\ 1 & 0 & 0 & 0 & 0 & 0 & 0 & 0 & 0 & 0 & 0 & 0 & 0 & 0 & 0 & 0 & 1 & 0 & 0 & 1 & 0 & 0 & 0 & 1 & 0 & 0 & 0 & 0 & 0 & 0 \\ 0 & 1 & 0 & 0 & 0 & 0 & 0 & 0 & 0 & 0 & 0 & 0 & 0 & 0 & 0 & 0 & 0 & 1 & 1 & 0 & 0 & 0 & 1 & 0 & 0 & 0 & 0 & 0 & 0 & 0 \\ 0 & 0 & 0 & 1 & 0 & 0 & 0 & 0 & 0 & 0 & 0 & 0 & 0 & 0 & 0 & 0 & 0 & 0 & 0 & 1 & 1 & 0 & 0 & 0 & 0 & 1 & 0 & 0 & 0 & 0 \\ 0 & 0 & 1 & 0 & 0 & 0 & 0 & 0 & 0 & 0 & 0 & 0 & 0 & 0 & 0 & 0 & 0 & 0 & 1 & 0 & 0 & 1 & 0 & 0 & 1 & 0 & 0 & 0 & 0 & 0 \\ 0 & 0 & 0 & 0 & 0 & 1 & 0 & 0 & 0 & 0 & 0 & 0 & 0 & 0 & 0 & 0 & 0 & 0 & 0 & 0 & 0 & 1 & 1 & 0 & 0 & 0 & 0 & 1 & 0 & 0 \\ 0 & 0 & 0 & 0 & 1 & 0 & 0 & 0 & 0 & 0 & 0 & 0 & 0 & 0 & 0 & 0 & 0 & 0 & 0 & 0 & 1 & 0 & 0 & 1 & 0 & 0 & 1 & 0 & 0 & 0 \\ 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 1 & 1 & 0 & 0 & 0 & 1 & 0 \\ 0 & 0 & 0 & 0 & 0 & 0 & 0 & 1 & 0 & 0 & 0 & 0 & 0 & 0 & 0 & 0 & 0 & 0 & 0 & 0 & 0 & 0 & 1 & 0 & 0 & 1 & 0 & 0 & 0 & 1 \\ 0 & 1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 1 & 1 & 0 & 0 & 0 \\ 1 & 0 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 1 & 0 & 0 & 1 & 0 & 0 \\ 0 & 0 & 1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 1 & 0 & 0 & 1 \\ 0 & 0 & 0 & 1 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 1 & 1 & 0 \\ 0 & 1 & 0 & 0 & 0 & 1 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 1 & 0 \\ 1 & 0 & 0 & 0 & 1 & 0 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 1\end{matrix}\right]$

In S1015, a parity check matrix is determined.

Exemplarily, the parity check matrix Hq has the same dimension as the binary extension matrix Hb, that is, the parity check matrix Hq is also composed of 15*15 block matrices with a dimension of 2*2, and the number and positions of non-zero elements in Hq and Hb are also the same. For example, the non-zero elements in the binary extension matrix Hb are 1 elements, while the non-zero elements in the parity check matrix Hq are non-zero elements {1, 2, 3, ..., 14, 15} in GF(q=16).

Thus, the values of the non-zero elements in the parity check matrix Hq may be determined by the dimension n of the binary base matrix, the candidate set C, and the non-zero non-binary element vector L.

The non-binary element vector L is composed of q-1 non-zero elements in a q-order Galois field, which may be L=[3 2 12 13 14 11 7 9 15 4 6 8 1 5 10]. The candidate set C is a set of non-binary element candidate vectors with different lengths, which may be shown in Table 2 below:

**Table 2**

| *C_{dc}* | ***c**ᵢ* |
|---|---|
| *C*₂ | ***c***₀ = [16] |
| *C*₃ | ***c***₀ = [1 7 6] |
| *C*₄ | ***c***₀ = [8 1 11 14] |
| *C*₅ | ***c***₀ = [15 2 10 6 1] |
| | ***c***₁ = [14 2 11 6 1] |
| | ***c***₂ = [15 8 12 10 1] |
| *C*₆ | ***c***₀ = [1 11 3 1 7 14] |
| *C*₇ | ***c***₀ = [2 13 6 7 15 5] |
| | ***c***₁ = [2 1 3 6 10 15 5] |
| | ***c***₂ = [2 13 7 12 15 5] |
| | ***c***₃ = [3 1 4 7 12 15 5] |
| *C*₈ | ***c***₀ = [11 5 3 3 115 114] |
| | ***c***₁ = [11 11 8 3 1 14 1 14] |
| | ***c***₂ = [11 5 3 3 2 15 1 14] |
| | ***c***₃ = [11 8 5 3 2 15 1 14] |
| | ***c***₄ = [11 8 6 5 2 15 1 14] |
| | ***c***₅ = [11 10 8 6 2 14 1 13] |
| | ***c***₆ = [12 11 10 8 4 14 1 13] |
| *C*₁₅ | ***c***₀ = [3 7 12 9 5 11 2 6 15 10 8 4 14 1 13] |
| | ***c***₁ = [12121413 12 13 10 12 15 13 13 12 14 114] |

Thus, based on the method shown in S51 to S53, the values of the non-zero elements in the parity check matrix Hq may be determined, and the obtained parity check matrix Hq may be expressed as: $Hq = \left[\begin{matrix}5 & 0 & 9 & 0 & 0 & 0 & 8 & 0 & 0 & 0 & 0 & 0 & 0 & 0 & 10 & 0 & 0 & 0 & 0 & 0 & 0 & 0 & 0 & 0 & 0 & 0 & 0 & 0 & 0 & 0 \\ 0 & 5 & 0 & 9 & 0 & 0 & 0 & 8 & 0 & 0 & 0 & 0 & 0 & 0 & 0 & 10 & 0 & 0 & 0 & 0 & 0 & 0 & 0 & 0 & 0 & 0 & 0 & 0 & 0 & 0 \\ 0 & 0 & 9 & 0 & 0 & 7 & 0 & 0 & 15 & 0 & 0 & 0 & 0 & 0 & 0 & 0 & 2 & 0 & 0 & 0 & 0 & 0 & 0 & 0 & 0 & 0 & 0 & 0 & 0 & 0 \\ 0 & 0 & 0 & 9 & 7 & 0 & 0 & 0 & 0 & 15 & 0 & 0 & 0 & 0 & 0 & 0 & 0 & 2 & 0 & 0 & 0 & 0 & 0 & 0 & 0 & 0 & 0 & 0 & 0 & 0 \\ 0 & 0 & 0 & 0 & 7 & 0 & 0 & 8 & 0 & 0 & 0 & 14 & 0 & 0 & 0 & 0 & 0 & 0 & 13 & 0 & 0 & 0 & 0 & 0 & 0 & 0 & 0 & 0 & 0 & 0 \\ 0 & 0 & 0 & 0 & 0 & 7 & 8 & 0 & 0 & 0 & 14 & 0 & 0 & 0 & 0 & 0 & 0 & 0 & 0 & 13 & 0 & 0 & 0 & 0 & 0 & 0 & 0 & 0 & 0 & 0 \\ 0 & 0 & 0 & 0 & 0 & 0 & 0 & 8 & 0 & 15 & 0 & 0 & 6 & 0 & 0 & 0 & 0 & 0 & 0 & 0 & 11 & 0 & 0 & 0 & 0 & 0 & 0 & 0 & 0 & 0 \\ 0 & 0 & 0 & 0 & 0 & 0 & 8 & 0 & 15 & 0 & 0 & 0 & 0 & 6 & 0 & 0 & 0 & 0 & 0 & 0 & 0 & 11 & 0 & 0 & 0 & 0 & 0 & 0 & 0 & 0 \\ 0 & 0 & 0 & 0 & 0 & 0 & 0 & 0 & 15 & 0 & 0 & 14 & 0 & 0 & 10 & 0 & 0 & 0 & 0 & 0 & 0 & 0 & 0 & 12 & 0 & 0 & 0 & 0 & 0 & 0 \\ 0 & 0 & 0 & 0 & 0 & 0 & 0 & 0 & 0 & 15 & 14 & 0 & 0 & 0 & 0 & 10 & 0 & 0 & 0 & 0 & 0 & 0 & 12 & 0 & 0 & 0 & 0 & 0 & 0 & 0 \\ 0 & 0 & 0 & 0 & 0 & 0 & 0 & 0 & 0 & 0 & 14 & 0 & 6 & 0 & 0 & 0 & 0 & 2 & 0 & 0 & 0 & 0 & 0 & 0 & 1 & 0 & 0 & 0 & 0 & 0 \\ 0 & 0 & 0 & 0 & 0 & 0 & 0 & 0 & 0 & 0 & 0 & 14 & 0 & 6 & 0 & 0 & 2 & 0 & 0 & 0 & 0 & 0 & 0 & 0 & 0 & 1 & 0 & 0 & 0 & 0 \\ 0 & 0 & 0 & 0 & 0 & 0 & 0 & 0 & 0 & 0 & 0 & 0 & 6 & 0 & 10 & 0 & 0 & 0 & 0 & 13 & 0 & 0 & 0 & 0 & 0 & 0 & 0 & 3 & 0 & 0 \\ 0 & 0 & 0 & 0 & 0 & 0 & 0 & 0 & 0 & 0 & 0 & 0 & 0 & 6 & 0 & 10 & 0 & 0 & 13 & 0 & 0 & 0 & 0 & 0 & 0 & 0 & 3 & 0 & 0 & 0 \\ 0 & 0 & 0 & 0 & 0 & 0 & 0 & 0 & 0 & 0 & 0 & 0 & 0 & 0 & 10 & 0 & 0 & 2 & 0 & 0 & 0 & 11 & 0 & 0 & 0 & 0 & 0 & 0 & 0 & 4 \\ 0 & 0 & 0 & 0 & 0 & 0 & 0 & 0 & 0 & 0 & 0 & 0 & 0 & 0 & 0 & 10 & 2 & 0 & 0 & 0 & 11 & 0 & 0 & 0 & 0 & 0 & 0 & 0 & 4 & 0 \\ 5 & 0 & 0 & 0 & 0 & 0 & 0 & 0 & 0 & 0 & 0 & 0 & 0 & 0 & 0 & 0 & 2 & 0 & 0 & 13 & 0 & 0 & 0 & 12 & 0 & 0 & 0 & 0 & 0 & 0 \\ 0 & 5 & 0 & 0 & 0 & 0 & 0 & 0 & 0 & 0 & 0 & 0 & 0 & 0 & 0 & 0 & 0 & 2 & 13 & 0 & 0 & 0 & 12 & 0 & 0 & 0 & 0 & 0 & 0 & 0 \\ 0 & 0 & 0 & 9 & 0 & 0 & 0 & 0 & 0 & 0 & 0 & 0 & 0 & 0 & 0 & 0 & 0 & 0 & 0 & 13 & 11 & 0 & 0 & 0 & 0 & 1 & 0 & 0 & 0 & 0 \\ 0 & 0 & 9 & 0 & 0 & 0 & 0 & 0 & 0 & 0 & 0 & 0 & 0 & 0 & 0 & 0 & 0 & 0 & 13 & 0 & 0 & 11 & 0 & 0 & 1 & 0 & 0 & 0 & 0 & 0 \\ 0 & 0 & 0 & 0 & 0 & 7 & 0 & 0 & 0 & 0 & 0 & 0 & 0 & 0 & 0 & 0 & 0 & 0 & 0 & 0 & 0 & 11 & 12 & 0 & 0 & 0 & 0 & 3 & 0 & 0 \\ 0 & 0 & 0 & 0 & 7 & 0 & 0 & 0 & 0 & 0 & 0 & 0 & 0 & 0 & 0 & 0 & 0 & 0 & 0 & 0 & 11 & 0 & 0 & 12 & 0 & 0 & 3 & 0 & 0 & 0 \\ 0 & 0 & 0 & 0 & 0 & 0 & 8 & 0 & 0 & 0 & 0 & 0 & 0 & 0 & 0 & 0 & 0 & 0 & 0 & 0 & 0 & 0 & 0 & 12 & 1 & 0 & 0 & 0 & 4 & 0 \\ 0 & 0 & 0 & 0 & 0 & 0 & 0 & 8 & 0 & 0 & 0 & 0 & 0 & 0 & 0 & 0 & 0 & 0 & 0 & 0 & 0 & 0 & 12 & 0 & 0 & 1 & 0 & 0 & 0 & 4 \\ 0 & 5 & 0 & 0 & 0 & 0 & 0 & 0 & 15 & 0 & 0 & 0 & 0 & 0 & 0 & 0 & 0 & 0 & 0 & 0 & 0 & 0 & 0 & 0 & 0 & 1 & 3 & 0 & 0 & 0 \\ 5 & 0 & 0 & 0 & 0 & 0 & 0 & 0 & 0 & 15 & 0 & 0 & 0 & 0 & 0 & 0 & 0 & 0 & 0 & 0 & 0 & 0 & 0 & 0 & 1 & 0 & 0 & 3 & 0 & 0 \\ 0 & 0 & 9 & 0 & 0 & 0 & 0 & 0 & 0 & 0 & 14 & 0 & 0 & 0 & 0 & 0 & 0 & 0 & 0 & 0 & 0 & 0 & 0 & 0 & 0 & 0 & 3 & 0 & 0 & 4 \\ 0 & 0 & 0 & 9 & 0 & 0 & 0 & 0 & 0 & 0 & 0 & 14 & 0 & 0 & 0 & 0 & 0 & 0 & 0 & 0 & 0 & 0 & 0 & 0 & 0 & 0 & 0 & 3 & 4 & 0 \\ 0 & 5 & 0 & 0 & 0 & 7 & 0 & 0 & 0 & 0 & 0 & 0 & 6 & 0 & 0 & 0 & 0 & 0 & 0 & 0 & 0 & 0 & 0 & 0 & 0 & 0 & 0 & 0 & 4 & 0 \\ 5 & 0 & 0 & 0 & 7 & 0 & 0 & 0 & 0 & 0 & 0 & 0 & 0 & 6 & 0 & 0 & 0 & 0 & 0 & 0 & 0 & 0 & 0 & 0 & 0 & 0 & 0 & 0 & 0 & 4\end{matrix}\right]$

It can be seen that all non-zero elements in the same circulant matrix of the parity check matrix are the same and all non-zero elements in the same column are the same.

In S102, NB-LDPC encoding is performed on the information bit sequence according to the parity check matrix or a generator matrix corresponding to the parity check matrix, to obtain an encoded sequence.

In some embodiments, based on the determined parity check matrix, Gaussian elimination and inversion may be performed on the parity check matrix, to obtain a generator matrix. A dimension of the generator matrix is determined by the dimension and rank of the parity check matrix. Exemplarily, the dimension of the parity check matrix is (n*Z)*(n*Z), and its rank is R, then the dimension of the generator matrix obtained after Gaussian elimination and inversion are performed on the parity check matrix is (n*(Z-R))*(n*Z).

Further, the NB-LDPC encoding is performed on the information bit sequence according to the parity check matrix or the generator matrix corresponding to the parity check matrix, to obtain the encoded sequence.

Exemplarily, the S102 is explained exemplarily below by taking an example of the parity check matrix determined in S1011 to S1015. The parity check matrix determined by S1011 to S1015 has a dimension of 30*30, and a rank of 22, then after Gaussian elimination and inversion are performed on the parity check matrix, the obtained generator matrix with a dimension of 8*30 may be expressed as: $G = \left[\begin{matrix}6 & 6 & 9 & 9 & 0 & 0 & 0 & 0 & 2 & 2 & 4 & 4 & 5 & 5 & 0 & 0 & 0 & 0 & 1 & 1 & 0 & 0 & 0 & 0 & 0 & 0 & 0 & 0 & 0 & 0 \\ 13 & 13 & 0 & 0 & 14 & 14 & 8 & 8 & 10 & 10 & 0 & 0 & 0 & 0 & 0 & 0 & 0 & 0 & 0 & 0 & 0 & 0 & 1 & 1 & 0 & 0 & 0 & 0 & 0 & 0 \\ 5 & 5 & 0 & 0 & 0 & 0 & 0 & 0 & 3 & 3 & 0 & 0 & 14 & 14 & 11 & 11 & 1 & 1 & 0 & 0 & 0 & 0 & 0 & 0 & 0 & 0 & 0 & 0 & 0 & 0 \\ 0 & 0 & 2 & 2 & 0 & 0 & 15 & 15 & 8 & 8 & 3 & 3 & 0 & 0 & 0 & 0 & 0 & 0 & 0 & 0 & 0 & 0 & 0 & 0 & 1 & 1 & 0 & 0 & 0 & 0 \\ 0 & 0 & 5 & 5 & 15 & 15 & 0 & 0 & 0 & 0 & 14 & 14 & 4 & 4 & 13 & 13 & 0 & 0 & 0 & 0 & 1 & 1 & 0 & 0 & 0 & 0 & 0 & 0 & 0 & 0 \\ 0 & 0 & 0 & 0 & 10 & 10 & 0 & 0 & 11 & 11 & 5 & 5 & 9 & 9 & 0 & 0 & 0 & 0 & 0 & 0 & 0 & 0 & 0 & 0 & 0 & 0 & 1 & 1 & 0 & 0 \\ 0 & 0 & 0 & 0 & 11 & 11 & 0 & 9 & 6 & 6 & 12 & 12 & 0 & 15 & 5 & 5 & 0 & 0 & 3 & 0 & 0 & 0 & 14 & 0 & 4 & 0 & 13 & 0 & 1 & 0 \\ 0 & 0 & 0 & 0 & 11 & 11 & 9 & 0 & 6 & 6 & 0 & 0 & 15 & 0 & 0 & 0 & 0 & 0 & 3 & 0 & 0 & 0 & 14 & 0 & 4 & 0 & 13 & 0 & 0 & 1\end{matrix}\right]$

In some embodiments, rate matching may also be performed on the LDPC codeword sequence according to a required encoding code rate, to output a to-be-sent codeword sequence with a corresponding length.

Based on the technical solutions provided in the present disclosure, a method for determining the parity check matrix of NB-LDPC is provided, the parity check matrix may be determined based on the determined binary extension matrix, the exponent matrix, the lifting factor, etc., so that it is unnecessary to store the parity check matrix when performing NB-LDPC code encoding, thereby reducing the storage space required in the NB-LDPC code encoding process. Moreover, the binary base matrix adopted in the NB-LDPC code encoding process may have a circulant matrix structure, further reducing the storage space required in the NB-LDPC code encoding process and the complexity of matrix construction involved in encoding.

In addition, the values of the non-zero elements in the parity check matrix may be determined based on at least one of the above binary base matrices, the binary extension matrix, the candidate set, the non-zero non-binary element vector, the primitive element of the Galois field corresponding to the order of the NB-LDPC codes, the dimension of the binary base matrix, or the lifting factor. Further, the binary extension matrix is determined based on the exponent matrix and the lifting factor. That is, when performing NB-LDPC code encoding, it is unnecessary to store the parity check matrix, and only at least one of the above binary base matrix, the exponent matrix, the candidate set, the non-zero non-binary element vector, the primitive element of the Galois field corresponding to the order of the NB-LDPC codes, the dimension of the binary base matrix, or the lifting factor is required to be stored, thereby reducing the storage space required in the NB-LDPC code encoding process.

In some embodiments, the present disclosure further provides a decoding method, as shown in FIG. 5, and the method includes: S201 toS202.

In S201, an encoded sequence is received.

In S202, the encoded sequence is decoded based on a parity check matrix of non-binary low density parity check (NB-LDPC) codes, to obtain an information bit sequence.

A dimension of the parity check matrix is determined based on a dimension of a binary extension matrix, the binary extension matrix is obtained by hashing an exponent matrix based on a lifting factor, and the lifting factor is determined based on the binary base matrix, the information bit sequence, and an order of the NB-LDPC codes.

In some embodiments, the binary base matrix has a non-full-rank circulant matrix structure.

In some embodiments, the binary base matrix is determined based on at least one of:
a preset generating set;
a primitive polynomial of a Galois field; or
a binary cyclic code.

In some embodiments, the dimension of the binary base matrix is determined based on any one of: a preset dimension value; or a dimension value configured via signaling.

In some embodiments, the lifting factor is determined based on a number of information columns of the binary base matrix, a number of bits of the information bit sequence, or the order of the NB-LDPC codes.

In some embodiments, the lifting factor satisfies a relationship as follows: $Z ∗ {k}_{b} ∗ \left⌊{log}_{2} q\right⌋ \geq K ;$ Z is the lifting factor, *k_{b}* is a number of columns of the binary base matrix, q is the order of the NB-LDPC codes, *K* is a number of bits of the information bit sequence, and $\left⌊⋅\right⌋$ represents rounding down.

In some embodiments, the exponent matrix includes a first element and a second element, the first element is used to indicate an all-zero square matrix, and the second element is used to indicate a binary circulant square matrix.

In some embodiments, a dimension of the exponent matrix is determined based on a dimension of the binary base matrix, a position of the first element is determined based on a position of an element with a value of 0 in the binary base matrix, and a position of the second element is determined based on a position of an element with a value of 1 in the binary base matrix.

In some embodiments, a row weight and a column weight of the binary circulant matrix are both 1, or a row weight and a column weight of the binary circulant square matrix are both greater than 1.

In some embodiments, the second element satisfies any one of:
the second element being used to indicate a cyclic shift value of the binary circulant square matrix;
the second element being used to indicate a row vector of a predefined row of the binary circulant square matrix; or
the second element being used to indicate a column index of an element with a value of 1 in a predefined row of the binary circulant square matrix.

In some embodiments, the binary extension matrix is determined based on the exponent matrix and the lifting factor; the first element in the exponent matrix is expanded into an all-zero square matrix based on the lifting factor, and the second element in the exponent matrix is expanded into a binary circulant square matrix based on the lifting factor.

In some embodiments, a number of non-zero elements in the parity check matrix is determined based on a number of non-zero elements in the binary extension matrix, and positions of the non-zero elements in the parity check matrix are determined based on positions of the non-zero elements in the binary extension matrix.

In some embodiments, the values of the non-zero elements in the parity check matrix are determined based on at least one of:
the binary base matrix;
the binary extension matrix;
a candidate set, where the candidate set includes non-binary element candidate vectors with a plurality of lengths;
a non-zero non-binary element vector;
a primitive element of a Galois field corresponding to the order of the NB-LDPC codes;
the dimension of the binary base matrix; or
the lifting factor.

In some embodiments, the parity check matrix satisfies any one of:
all non-zero elements in any one of circulant square matrices of the parity check matrix being the same;
there being different non-zero elements in at least one circulant square matrix of the parity check matrix;
all non-zero elements in any one of columns of elements of the parity check matrix being the same; or
there being different non-zero elements in at least one column of elements of the parity check matrix.

In addition, for the detailed description of S201 to S202, reference may be made to the related description of the above S101 to S102, which will not be repeated here.

Based on the technical solutions provided in the present disclosure, the binary base matrix adopted in the NB-LDPC code decoding process may have a circulant matrix structure, further reducing the storage space required in the NB-LDPC code decoding process and the complexity of matrix construction involved in decoding.

It can be understood that, in order to implement the above functions, an encoding apparatus and a decoding apparatus contains corresponding hardware structures and/or software modules for performing various functions. Those skilled in the art should easily realize that the present disclosure can be implemented in the form of hardware or a combination of hardware and computer software, in combination with the algorithm steps of various examples described in the embodiments of the present disclosure. Whether a certain function is executed by hardware or by computer software driving hardware, depends on the specific applications and design constraint conditions of the technical solutions. Professional technicians may use different methods to implement the described functions for each specific application, but such an implementation should not be considered beyond the scope of the present disclosure.

In the embodiments of the present disclosure, the encoding apparatus or decoding apparatus may be divided into functional modules according to the above method embodiments, and for example, each functional module may be divided corresponding to each function, or two or more functions may be integrated into one functional module. The above integrated module is implemented in the form of hardware or in the form of software. It should be noted that the division of modules in the embodiments of the present disclosure is illustrative, and is merely a kind of logical functional division, and there may be other division methods in actual implementations. The example in which each functional module may be divided corresponding to each function is taken for explanation below.

FIG. 6 is a structural schematic diagram of an encoding apparatus, provided in the embodiments of the present disclosure, and the encoding apparatus may perform the encoding method provided in the above method embodiments. As shown in FIG. 6, the encoding apparatus includes: a determining module 601 and an encoding module 602.

The determining module 601, is configured to determine a parity check matrix. A dimension of the parity check matrix is determined based on a dimension of a binary extension matrix, the binary extension matrix is obtained by hashing an exponent matrix based on a lifting factor, and the lifting factor is determined based on a binary base matrix, an information bit sequence, and an order of non-binary low density parity check (NB-LDPC) codes.

The encoding module 602, is configured to perform NB-LDPC encoding on the information bit sequence according to the parity check matrix or a generator matrix corresponding to the parity check matrix, to obtain an encoded sequence.

In some embodiments, the binary base matrix has a non-full-rank circulant matrix structure.

In some embodiments, the binary base matrix is determined based on at least one of:
a preset generating set;
a primitive polynomial of a Galois field; or
a binary cyclic code.

In some embodiments, a dimension of the binary base matrix is determined based on any one of: a preset dimension value; or a dimension value configured via signaling.

In some embodiments, the lifting factor is determined based on a number of information columns of the binary base matrix, a number of bits of the information bit sequence, and the order of the NB-LDPC codes.

In some embodiments, the lifting factor satisfies a relationship as follows: $Z ∗ {k}_{b} ∗ \left⌊{log}_{2} q\right⌋ \geq K ;$ where Z is the lifting factor,k_{b}is a number of columns of the binary base matrix, q is the order of the NB-LDPC codes, K is a number of bits of the information bit sequence, and $\left⌊⋅\right⌋$ represents rounding down.

In some embodiments, the exponent matrix includes a first element and a second element, the first element is used to indicate an all-zero square matrix, and the second element is used to indicate a binary circulant square matrix.

In some embodiments, a dimension of the exponent matrix is determined based on a dimension of the binary base matrix, a position of the first element is determined based on a position of an element with a value of 0 in the binary base matrix, and a position of the second element is determined based on a position of an element with a value of 1 in the binary base matrix.

In some embodiments, a row weight and a column weight of the binary circulant square matrix are both 1, or a row weight and a column weight of the binary circulant square matrix are both greater than 1.

In some embodiments, the second element satisfies any one of:
the second element being used to indicate a cyclic shift value of the binary circulant square matrix;
the second element being used to indicate a row vector of a predefined row of the binary circulant square matrix; or
the second element being used to indicate a column index of an element with a value of 1 in a predefined row of the binary circulant square matrix.

In some embodiments, the binary extension matrix is determined based on the exponent matrix and the lifting factor; the first element in the exponent matrix is expanded into the all-zero square matrix based on the lifting factor, and the second element in the exponent matrix is expanded into the binary circulant square matrix based on the lifting factor.

In some embodiments, a number of non-zero elements in the parity check matrix is determined based on a number of non-zero elements in the binary extension matrix, and positions of the non-zero elements in the parity check matrix are determined based on positions of the non-zero elements in the binary extension matrix.

In some embodiments, values of the non-zero elements in the parity check matrix are determined based on at least one of:
the binary base matrix;
the binary extension matrix;
a candidate set, where the candidate set includes non-binary element candidate vectors with a plurality of lengths;
a non-zero non-binary element vector;
a primitive element of a Galois field corresponding to the order of the NB-LDPC codes;
the dimension of the binary base matrix; or
the lifting factor.

In some embodiments, the parity check matrix satisfies any one of:
all non-zero elements in any one of circulant square matrices of the parity check matrix being the same;
there being different non-zero elements in at least one circulant square matrix of the parity check matrix;
all non-zero elements in any one of columns of elements of the parity check matrix being the same; or
there being different non-zero elements in at least one column of elements of the parity check matrix.

For more detailed descriptions of the above determining module 601 and encoding module 602, and more detailed descriptions of various technical features, and descriptions of the beneficial effects, etc., references may be made to the above corresponding method embodiment sections, which will not be repeated herein.

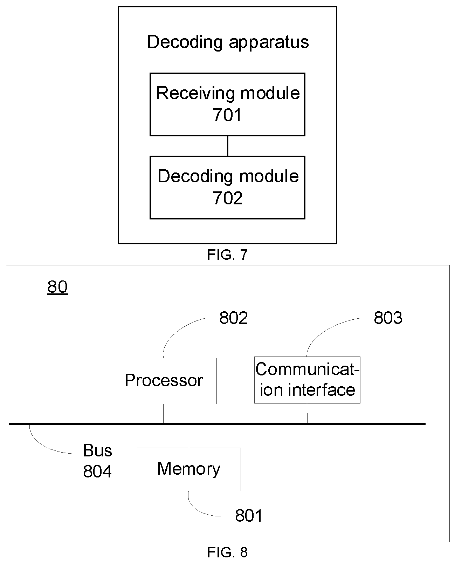

FIG. 7 is a schematic structural diagram of a decoding apparatus, provided in the embodiments of the present disclosure, and the decoding apparatus may perform the decoding method provided in the above method embodiments. As shown in FIG. 7, the decoding apparatus includes: a receiving module 701 and a decoding module 702.

The receiving module 701, is configured to receive an encoded sequence;
the decoding module 702, is configured to decode the encoded sequence based on a parity check matrix of non-binary low density parity check (NB-LDPC) codes, to obtain an information bit sequence; a dimension of the parity check matrix is determined based on a dimension of a binary extension matrix, the binary extension matrix is obtained by hashing an exponent matrix based on a lifting factor, and the lifting factor is determined based on a binary base matrix, the information bit sequence, and an order of the NB-LDPC codes.

In some embodiments, the binary base matrix has a non-full-rank circulant matrix structure.

In some embodiments, the binary base matrix is determined based on at least one of:
a preset generating set;
a primitive polynomial of a Galois field; or
a binary cyclic code.

In some embodiments, a dimension of the binary base matrix is determined based on any one of: a preset dimension value; or a dimension value configured via signaling.

In some embodiments, the lifting factor is determined based on a number of information columns of the binary base matrix, a number of bits of the information bit sequence, and the order of the NB-LDPC codes.

In some embodiments, the lifting factor satisfies a relationship as follows: $Z ∗ {k}_{b} ∗ \left⌊{log}_{2} q\right⌋ \geq K ;$ where Z is the lifting factor,k_{b}is a number of columns of the binary base matrix, q is the order of the NB-LDPC codes, K is a number of bits of the information bit sequence, and $\left⌊⋅\right⌋$ represents rounding down.

In some embodiments, the exponent matrix includes a first element and a second element, the first element is used to indicate an all-zero square matrix, and the second element is used to indicate a binary circulant square matrix.

In some embodiments, a dimension of the exponent matrix is determined based on a dimension of the binary base matrix, a position of the first element is determined based on a position of an element with a value of 0 in the binary base matrix, and a position of the second element is determined based on a position of an element with a value of 1 in the binary base matrix.

In some embodiments, a row weight and a column weight of the binary circulant square matrix are both 1, or a row weight and a column weight of the binary circulant square matrix are both greater than 1.

In some embodiments, the second element satisfies any one of:
the second element being used to indicate a cyclic shift value of the binary circulant square matrix;
the second element being used to indicate a row vector of a predefined row of the binary circulant square matrix; or
the second element being used to indicate a column index of an element with a value of 1 in a predefined row of the binary circulant square matrix.

In some embodiments, the binary extension matrix is determined based on the exponent matrix and the lifting factor; the first element in the exponent matrix is expanded into the all-zero square matrix based on the lifting factor, and the second element in the exponent matrix is expanded into the binary circulant square matrix based on the lifting factor.

In some embodiments, a number of non-zero elements in the parity check matrix is determined based on a number of non-zero elements in the binary extension matrix, and positions of the non-zero elements in the parity check matrix are determined based on positions of the non-zero elements in the binary extension matrix.

In some embodiments, values of the non-zero elements in the parity check matrix are determined based on at least one of:
the binary base matrix;
the binary extension matrix;
a candidate set, where the candidate set includes non-binary element candidate vectors with a plurality of lengths;
a non-zero non-binary element vector;
a primitive element of a Galois field corresponding to the order of the NB-LDPC codes;
the dimension of the binary base matrix; or
the lifting factor.

In some embodiments, the parity check matrix satisfies any one of:
all non-zero elements in any one of circulant square matrices of the parity check matrix being the same;
there being different non-zero elements in at least one circulant square matrix of the parity check matrix;
all non-zero elements in any one of columns of elements of the parity check matrix being the same; or
there being different non-zero elements in at least one column of elements of the parity check matrix

For more detailed descriptions of the above receiving module 701 and decoding module 702, and more detailed descriptions of various technical features, and descriptions of the beneficial effects, etc., references may be made to the above corresponding method embodiment sections, which will not be repeated herein.

In a case of implementing the functions of the above integrated modules in the form of hardware, the embodiments of the present disclosure provide another possible structure of a communication apparatus (which may be the above encoding apparatus or decoding apparatus) involved in the above embodiments. As shown in FIG. 8, the communication apparatus 80 includes a processor 802 and a bus 804. In some embodiments, the communication apparatus may further include a memory 801; in some embodiments, the communication apparatus may further include a communication interface 803.

The processor 802 may implement or perform various exemplary logical blocks, modules and circuits described in conjunction with the embodiments of the present disclosure. The processor 802 may be a central processing unit, a general-purpose processor, a digital signal processor, an application specific integrated circuit, a field programmable gate array or any other programmable logic device, a transistor logic device, a hardware component, or any combination thereof. The processor 802 may implement or perform various exemplary logical blocks, modules and circuits described in conjunction with the embodiments of the present disclosure. The processor 802 may also be a combination that implements computing functions, for example, including a combination of one or more microprocessors, a combination of a digital signal processor (DSP) and a microprocessor, or the like.

The communication interface 803 (also referred to as a transmitter) is configured to connect with other devices via a communication network. The communication network may be an Ethernet, a radio access network, a wireless local area network (WLAN), or the like.

The memory 801 may be, but be not limited to, a read-only memory (ROM) or other types of static storage devices capable of storing static information and instructions, a random access memory (RAM) or other types of dynamic storage devices capable of storing information and instructions, or may also be an electrically erasable programmable read-only memory (EEPROM), a magnetic disk storage medium or other magnetic storage devices, or any other medium capable of being used to carry or store the desired program codes in the form of instructions or data structures and capable of being accessed by a computer.

As an implementation, the memory 801 may exist independently of the processor 802, and the memory 801 may be connected to the processor 802 via the bus 804 and is used for storing instructions or program codes. The processor 802, when calling and executing the instructions or program codes stored in the memory 801, is capable of implementing the encoding method and decoding method provided in the embodiments of the present disclosure.

As another implementation, the memory 801 may be integrated with the processor 802.

The bus 804 may be an extended industry standard architecture (EISA) bus or the like. Buses 804 may be divided into address buses, data buses, control buses, and the like. For ease of representation, only one bold line is used for the representation in FIG. 8, but it does not mean that there is only one bus or one type of the bus.

From the description of the above embodiments, those skilled in the art can clearly understand that, for convenience and brevity of description, an illustration is only given by the division of functional modules mentioned above. In practical applications, the functions mentioned above may be allocated to be completed by different functional modules according to requirements. That is, the internal structure of the device or apparatus is divided into different functional modules to complete all or a part of the functions mentioned above.

The embodiments of the present disclosure further provide a computer readable storage medium. All or a part of the procedures in the above method embodiments may be completed by related hardware indicated by computer instructions, and the program may be stored in the above computer readable storage medium. The program, upon being executed, may include the procedures of the above method embodiments. The computer readable storage medium may be or a memory of the device or apparatus of any of the foregoing embodiments. The above computer readable storage medium may also be an external storage device of the device or apparatus mentioned above, e.g., a plug-in hard disk, a smart memory card (smart media card, SMC), a secure digital (SD) card, a flash card, etc., equipped on the above device or apparatus. Furthermore, the above computer readable storage medium may further include both an internal storage unit and an external storage device of the above device or apparatus. The above computer readable storage medium is used to store the above computer program, and other programs and data required for the above device or apparatus. The above computer readable storage medium may also be used to temporarily store data that has been output or is to be output. The readable storage medium includes a non-transitory computer readable storage medium.

The embodiments of the present disclosure further provide a computer program product, the computer product contains a computer program, the computer program product, when executed on a computer, causes the computer to perform any one of the methods provided in the above embodiments.

Although the present disclosure is described herein in conjunction with respective embodiments, other variations of the disclosed embodiments may be understood and implemented by those skilled in the art by viewing the drawings, the disclosed content, and the attached claims, in the process of implementing the claimed processes of the present disclosure. In the claims, the word "comprise/comprises/comprising" does not exclude other components or steps, and "a/an" or "one" does not exclude multiple cases. A single processor or other unit may implement functions of several items listed in the claims. Although certain measures are recorded in dependent claims different from each other, it does not mean that these measures cannot be combined to exert a good effect.

Although the present disclosure is described in conjunction with detailed features and embodiments thereof, it is apparent that various modifications and combinations may be made thereto without departing from the spirit and scope of the present disclosure. Accordingly, the specification and drawings are merely exemplary explanations of the present disclosure as defined by the attached claims and are deemed to cover any and all modifications, variations, combinations or equivalents within the scope of the present disclosure. Obviously, those skilled in the art may make various modifications and variants to the present disclosure without departing from the spirit and scope of the present disclosure. In this way, if these modifications and variations of the present disclosure fall within the scope of the claims of the present disclosure and their equivalent technologies, the present disclosure is also intended to include these modifications and variations therein.

The above descriptions are only specific implementations of the present disclosure, but the protection scope of the present disclosure is not limited thereto, any changes or replacements within the technical scope disclosed in the present disclosure shall be included in the protection scope of the present disclosure. Therefore, the protection scope of the present disclosure shall be determined based on the protection scope of the claims.

## Claims

1. An encoding method, **characterized by** comprising:
determining a parity check matrix, wherein a dimension of the parity check matrix is determined based on a dimension of a binary extension matrix, the binary extension matrix is obtained by hashing an exponent matrix based on a lifting factor, and the lifting factor is determined based on a binary base matrix, an information bit sequence, and an order of non-binary low density parity check, NB-LDPC, codes; and
performing NB-LDPC encoding on the information bit sequence according to the parity check matrix or a generator matrix corresponding to the parity check matrix, to obtain an encoded sequence.

2. The method according to claim 1, wherein the binary base matrix has a non-full-rank circulant matrix structure.

3. The method according to claim 1, wherein the binary base matrix is determined based on at least one of:
a preset generating set;
a primitive polynomial of a Galois field; or
a binary cyclic code.

4. The method according to claim 1, wherein a dimension of the binary base matrix is determined based on any one of: a preset dimension value; or a dimension value configured via signaling.

5. The method according to claim 1, wherein the lifting factor is determined based on a number of information columns of the binary base matrix, a number of bits of the information bit sequence, and the order of the NB-LDPC codes.

6. The method according to claim 5, wherein the lifting factor satisfies a relationship as follows: $Z ∗ {k}_{b} ∗ \left⌊{log}_{2} q\right⌋ \geq K ;$ wherein Z is the lifting factor, *k_{b}* is a number of columns of the binary base matrix, q is the order of the NB-LDPC codes, K is a number of bits of the information bit sequence, and $\left⌊⋅\right⌋$ represents rounding down.

7. The method according to claim 1, wherein the exponent matrix comprises a first element and a second element, the first element is used to indicate an all-zero square matrix, and the second element is used to indicate a binary circulant square matrix.

8. The method according to claim 7, wherein a dimension of the exponent matrix is determined based on a dimension of the binary base matrix, a position of the first element is determined based on a position of an element with a value of 0 in the binary base matrix, and a position of the second element is determined based on a position of an element with a value of 1 in the binary base matrix.

9. The method according to claim 7, wherein a row weight and a column weight of the binary circulant square matrix are both 1, or a row weight and a column weight of the binary circulant square matrix are both greater than 1.

10. The method according to claim 7, wherein the second element satisfies any one of:
the second element being used to indicate a cyclic shift value of the binary circulant square matrix;
the second element being used to indicate a row vector of a predefined row of the binary circulant square matrix; or
the second element being used to indicate a column index of an element with a value of 1 in a predefined row of the binary circulant square matrix.

11. The method according to claim 7, wherein the binary extension matrix is determined based on the exponent matrix and the lifting factor; the first element in the exponent matrix is expanded into the all-zero square matrix based on the lifting factor, and the second element in the exponent matrix is expanded into the binary circulant square matrix based on the lifting factor.

12. The method according to claim 1, wherein a number of non-zero elements in the parity check matrix is determined based on a number of non-zero elements in the binary extension matrix, and a position of the non-zero element in the parity check matrix is determined based on a position of the non-zero element in the binary extension matrix.

13. The method according to claim 1, wherein a value of a non-zero element in the parity check matrix is determined based on at least one of:
the binary base matrix;
the binary extension matrix;
a candidate set, wherein the candidate set comprises non-binary element candidate vectors with a plurality of lengths;
a non-zero non-binary element vector;
a primitive element of a Galois field corresponding to the order of the NB-LDPC codes;
a dimension of the binary base matrix; or
the lifting factor.

14. The method according to claim 1, wherein the parity check matrix satisfies any one of:
all non-zero elements in any one of circulant square matrices of the parity check matrix being the same;
there being different non-zero elements in at least one circulant square matrix of the parity check matrix;
all non-zero elements in any one of columns of elements of the parity check matrix being the same; or
there being different non-zero elements in at least one column of elements of the parity check matrix.

15. A decoding method, **characterized by** comprising:
receiving an encoded sequence; and
decoding the encoded sequence based on a parity check matrix of non-binary low density parity check, NB-LDPC, codes, to obtain an information bit sequence; wherein a dimension of the parity check matrix is determined based on a dimension of a binary extension matrix, the binary extension matrix is obtained by hashing an exponent matrix based on a lifting factor, and the lifting factor is determined based on a binary base matrix, the information bit sequence, and an order of the NB-LDPC codes.

16. The method according to claim 15, wherein the binary base matrix has a non-full-rank circulant matrix structure.

17. The method according to claim 15, wherein the binary base matrix is determined based on at least one of:
a preset generating set;
a primitive polynomial of a Galois field; or
a binary cyclic code.

18. The method according to claim 15, wherein a dimension of the binary base matrix is determined based on any one of: a preset dimension value; or a dimension value configured via signaling.

19. The method according to claim 15, the lifting factor is determined based on a number of information columns of the binary base matrix, a number of bits of the information bit sequence, and the order of the NB-LDPC codes.

20. The method according to claim 19, wherein the lifting factor satisfies a relationship as follows: $Z ∗ {k}_{b} ∗ \left⌊{log}_{2} q\right⌋ \geq K ;$ wherein Z is the lifting factor, *k_{b}* is a number of columns of the binary base matrix, q is the order of the NB-LDPC codes, K is a number of bits of the information bit sequence, and $\left⌊⋅\right⌋$ represents rounding down.

21. The method according to claim 15, wherein the exponent matrix comprises a first element and a second element, the first element is used to indicate an all-zero square matrix, and the second element is used to indicate a binary circulant square matrix.

22. The method according to claim 21, wherein a dimension of the exponent matrix is determined based on a dimension of the binary base matrix, a position of the first element is determined based on a position of an element with a value of 0 in the binary base matrix, and a position of the second element is determined based on a position of an element with a value of 1 in the binary base matrix.

23. The method according to claim 21, wherein a row weight and a column weight of the binary circulant square matrix are both 1, or a row weight and a column weight of the binary circulant square matrix are both greater than 1.

24. The method according to claim 21, wherein the second element satisfies any one of:
the second element being used to indicate a cyclic shift value of the binary circulant square matrix;
the second element being used to indicate a row vector of a predefined row of the binary circulant square matrix; or
the second element being used to indicate a column index of an element with a value of 1 in a predefined row of the binary circulant square matrix.

25. The method according to claim 21, wherein the binary extension matrix is determined based on the exponent matrix and the lifting factor; the first element in the exponent matrix is expanded into the all-zero square matrix based on the lifting factor, and the second element in the exponent matrix is expanded into the binary circulant square matrix based on the lifting factor.

26. The method according to claim 15, wherein a number of non-zero elements in the parity check matrix is determined based on a number of non-zero elements in the binary extension matrix, and a position of the non-zero element in the parity check matrix is determined based on a position of the non-zero element in the binary extension matrix.

27. The method according to claim 15, wherein a value of a non-zero element in the parity check matrix is determined based on at least one of:
the binary base matrix;
the binary extension matrix;
a candidate set, wherein the candidate set comprises non-binary element candidate vectors with a plurality of lengths;
a non-zero non-binary element vector;
a primitive element of a Galois field corresponding to the order of the NB-LDPC codes;
a dimension of the binary base matrix; or
the lifting factor.

28. The method according to claim 15, wherein the parity check matrix satisfies any one of:
all non-zero elements in any one of circulant square matrices of the parity check matrix being the same;
there being different non-zero elements in at least one circulant square matrix of the parity check matrix;
all non-zero elements in any one of columns of elements of the parity check matrix being the same; or
there being different non-zero elements in at least one column of elements of the parity check matrix.

29. A communication apparatus, **characterized by** comprising: a memory and a processor; the memory is coupled with the processor; the memory is configured to store instructions executable by the processor; and the processor upon executing the instructions, performs the method according to any one of claims 1 to 28.

30. A computer readable storage medium, **characterized in that** the computer readable storage medium has stored computer instructions thereon, and the computer instructions, upon being executed on a communication apparatus, enable the communication apparatus to perform the method according to any one of claims 1 to 28.
